(19) Europäisches Patentamt
European Patent Office
Office européen des brevets

(11) **EP 3 376 551 A1**

(12) **EUROPEAN PATENT APPLICATION**

(43) Date of publication:
**19.09.2018 Bulletin 2018/38**

(51) Int Cl.:
***H01L 51/46*** *(2006.01)*

(21) Application number: **18161698.8**

(22) Date of filing: **14.03.2018**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **14.03.2017 KR 20170031795**
**13.03.2018 KR 20180029304**

(71) Applicant: **Korea Research Institute of Chemical Technology**
**Daejeon 34114 (KR)**

(72) Inventors:
- **Seo, Jang Won**
  **04755 Seoul (KR)**
- **Jeon, Nam Joong**
  **61257 Gwangju (KR)**
- **Yang, Tae Youl**
  **34114 Daejeon (KR)**
- **Noh, Jun Hong**
  **34200 Daejeon (KR)**
- **Kim, Young Chan**
  **34116 Daejeon (KR)**
- **Park, Eun Young**
  **34423 Daejeon (KR)**

(74) Representative: **Herrmann, Uwe**
**Lorenz Seidler Gossel**
**Rechtsanwälte Patentanwälte**
**Partnerschaft mbB**
**Widenmayerstraße 23**
**80538 München (DE)**

(54) **POROUS METAL HALIDE FILM, FABRICATION METHOD THEREOF, AND FABRICATION METHOD OF ORGANOMETAL HALIDE HAVING PEROVSKITE STRUCTURE USING THE SAME**

(57) Provided are a porous metal halide film that reacts with an organic halide to be converted into an organometal halide having a perovskite structure, thereby fabricating the organometal halide, a fabrication method thereof, and a fabrication method of an organometal halide having a perovskite structure using the same, and specifically, the porous metal halide film according to the present disclosure satisfies Relational Expression 1 below:

(Relational Expression 1)

$$I(101)/I(001) \geq 0.5$$

in Relational Expression 1, 1(101) is a diffraction intensity of a (101) plane in X-ray diffraction pattern using a Cu Kα line of the porous metal halide film, and I(001) is a diffraction intensity of the (001) plane in the same X-ray diffraction pattern.

EP 3 376 551 A1

## Description

### TECHNICAL FIELD

The following disclosure relates to a porous metal halide film, a fabrication method thereof, and a fabrication method of an organometal halide having a perovskite structure using the same, and more specifically, to a porous metal halide film capable of being converted into an organometal halide having a perovskite structure in which a photoelectric conversion efficiency is excellent in an extremely short time, a fabrication method thereof, and a fabrication method of an organometal halide having a perovskite structure using the same.

### BACKGROUND

An organometal halide having a perovskite structure, also referred to as an organometal halide perovskite compound or an organic-inorganic perovskite compound is a substance including an organic cation (A), a metal cation (M), and a halogen anion (X), and being represented by Chemical Formula $AMX_3$.

Currently, a perovskite solar cell that use the organic-inorganic perovskite compound as a light absorber is the most commercialized among next generation solar cells including dye sensitized and organic solar cells, and has been reported to have an efficiency up to 20% (Korea Patent Publication No. 2014-0035284), and thus an interest in the organic-inorganic perovskite compound is further increasing.

The organic-inorganic perovskite compound has very low material cost and is capable of being subjected to a low-temperature process or a low-cost solution process to have excellent commercial viability. However, researches on a commercialization process and large-scale production that are capable of being mass-produced such as a continuous roll-to-roll process are insufficient.

[Related Art Document]

(Patent Document 1) Korean Patent Laid-Open Publication No. 2014-0035284

### SUMMARY

An embodiment of the present disclosure is directed to providing a metal halide film capable of being converted into an organometal halide having a perovskite structure in an extremely short time to thereby be capable of mass-producing an organometal halide-containing device by a process having excellent commercial viability such as a continuous process.

Another embodiment of the present disclosure is directed to providing a metal halide film capable of being converted into an organometal halide having excellent photoelectric conversion property by controlling crystal orientation.

Still another embodiment of the present disclosure is directed to providing a fabrication method of a metal halide film.

Still another embodiment of the present disclosure is directed to providing a fabrication method of an organometal halide having a perovskite structure using a metal halide film.

In one general aspect, there is provided a porous metal halide film satisfying Relational Expression 1 below:

(Relational Expression 1)

$$I(101)/I(001) \geq 0.5$$

in Relational expression 1, I(101) is a diffraction intensity of a (101) plane in X-ray diffraction pattern using a Cu K$\alpha$ line of the porous metal halide film, and I(001) is a diffraction intensity of the (001) plane in the same X-ray diffraction pattern.

The I(101)/I(001) may be 5 or more.

In a grazing incidence wide angle X-ray scattering (GIWAXS) spectrum, the metal halide film may have a continuous scattering intensity in a azimuthal angle(radiation angle) range of 10 to 80 degrees based on a scattering intensity of the (101) plane according to the azimuthal angle, and may further satisfy Relational Expressions 2 and 3 below:

(Relational Expression 2)

$$0.7 \leq I55/I10 \leq 1.5$$

I55 is an intensity at a azimuthal angle of 55 degrees based on a scattering intensity of a (101) plane according to the azimuthal angle, and I10 is an intensity at a azimuthal angle of 10 degrees based on the scattering intensity of the (101) plane according to the same azimuthal angle:

(Relational Expression 3)

$$0.7 \leq I55/I80 \leq 1.5$$

I55 is the same as defined in the Relational Expression 2, and I80 is an intensity at a azimuthal angle of 80 degrees based on the scattering intensity of the (101) plane according to the azimuthal angle.

The porous metal halide film may further satisfy Relational Expression 4 below:

(Relational Expression 4)

$$Ap \geq 0.05$$

in Relational Expression 4, Ap means an area occupied by pores per unit area of the porous metal halide film.

The porous metal halide film may further satisfy Relational Expression 5 below:

(Relational Expression 5)

$$|Ap(center)-Ap(corner)|/Ap(center) * 100 \leq 10\%$$

in Relational Expression 5, Ap (center) means an area occupied by pores per unit area in a central region of a porous metal halide film based on a size of 2 inches by 2 inches, and Ap (corner) means an area occupied by pores per unit area in an edge region of the porous metal halide film having the same size as above.

The metal halide film may have a thickness of 1 $\mu$m to 1000 $\mu$m.

The metal halide film may be reacted with an organic halide to be converted into an organometal halide having a perovskite structure (perovskite compound), thereby fabricating the organometal halide (perovskite compound).

In another general aspect, there is provided a fabrication method of a porous metal halide film including: contacting a precursor film (adduct layer) containing an adduct of metal halide and guest molecule with a polar protic solvent satisfying Relational Expression 6 below to fabricate a porous metal halide film:

(Relational Expression 6)

$$\delta_h(gm) < \delta_h(pa)$$

in Relational Expression 6, $\delta_h$(gm) is a hydrogen bonding component ($\delta_h$, $MPa^{0.5}$) in a Hansen solubility parameter of the guest molecule, and $\delta_h$(pa) is a hydrogen bonding component ($\delta_h$, $MPa^{0.5}$) in a Hansen solubility parameter of the polar protic solvent.

The polar protic solvent may further satisfy Relational Expressions 7 and 8 below:

(Relational Expression 7)

$$0.8 \leq \delta_t(pa)/\delta_t(gm) \leq 1.1$$

in Relational Expression 7, $\delta_t$(gm) is a Hansen solubility parameter ($MPa^{0.5}$) of the guest molecule, and $\delta_t$ (pa) is a Hansen solubility parameter ($MPa^{0.5}$) of the polar protic solvent, and

(Relational Expression 8)

$$7.0 \leq \delta_p(gm) - \delta_p(pa) \leq 15.0$$

in Relational Expression 8, $\delta_p$(gm) is a dispersion component ($\delta_p$, $MPa^{0.5}$) in a Hansen solubility parameter of the guest molecule, and $\delta_p$(pa) is a dispersion component ($\delta_p$, $MPa^{0.5}$) in a Hansen solubility parameter ($MPa^{0.5}$) of the polar protic solvent.

The polar protic solvent may further satisfy Relational Expression 9 below:

(Relational Expression 9)

$$0.5 \leq Vm(pa)/Vm(gm) \leq 1.15$$

in Relational Expression 9, $V_m$(pa) is a molar volume of the polar protic solvent and $V_m$(gm) is a molar volume of the guest molecule.

The guest molecule may be a solvent of the metal halide.

The guest molecule may be dimethylsulfoxide (DMSO), N-methyl-2-pyrrolidone (NMP), 2,2'-bipyridine, 4,4'-bipyridine-N,N'-dioxide, pyrazine, 1,10-phenanthroline, 2-methylpyridine or poly(ethylene oxide).

The polar protic solvent may be an alcohol-based solvent.

The fabrication method may further include a) forming the precursor film containing an adduct of metal halide and guest molecule by applying an adduct solution containing the metal halide and the guest molecule on a substrate; and b) forming the porous metal halide film by contacting the precursor film with the polar protic solvent.

Steps a) and b) may be continuous processes.

The substrate of step a) may be a flexible substrate, and steps a) and b) may be roll-to-roll continuous processes.

Step a) may be performed by a printing process including slot die, bar coater, gravure, offset, or doctor blade.

The adduct solution may contain 1 to 2.5 mol of guest molecules relative to 1 mol of the metal halide.

A contact time between the precursor film and the polar protic solvent may be within 1 minute.

The adduct solution may further contain a viscosity modifier, and in step b), the viscosity modifier contained in the precursor film may be removed by the polar protic solvent.

In still another general aspect, there is provided a fabrication method of an organometal halide film including: c) fabricating a porous metal halide film by the fabrication method of a porous metal halide as described above; and d) contacting the porous metal halide film with an organic halide to fabricate the organometal halide film having a perovskite structure.

Step d) may be performed by contacting the porous metal halide film with an organic halide solution, and a concentration of the organic halide solution may be 35 mg/ml or more.

In step d), a contact time between the porous metal halide film and the organic halide may be within 1 minute.

After step d), the fabrication method may further include annealing the organometal halide film fabricated in step d).

Step c) may be performed on a substrate on which a first electrode and a first charge carrier are sequentially formed.

The first charge carrier may be a stacked body of a dense film and a porous film or may be a dense film.

## BRIEF DESCRIPTION OF THE DRAWINGS

FIG. 1 shows results of X-ray diffraction analysis of a film prepared in Example 1 (IPA), a precursor film of an adduct of metal halide and guest molecule (ref) and a film fabricated in Comparative Example 2 (heating).

FIG. 2 shows scanning electron microscope images showing a surface (left side) and an end surface (right side) of each of the film fabricated in Example 1 (IPA), the precursor film of an adduct of metal halide and guest molecule (ref), and the film fabricated in Comparative Example 2 (heating).

FIG. 3 shows scanning electron microscope (SEM) images of the surface of each of Example 1 (IPA) and Comparative Example 1 (CB).

FIG. 4 shows optical microscope images observed after dipping each of Example 1 (IPA 20 sec), Example 2 (IPA 10 sec), Comparative Example 1 (CB 20 sec), Comparative Example 3 (CB 10 sec) and the precursor film of an adduct of metal halide and guest molecule ($PbI_2$-DMSO) in an organic halide solution for 10 seconds, 20 seconds, or 30 seconds.

FIG. 5 shows ultraviolet-visible light absorption spectrum of films fabricated by dipping each of Example 1 (IPA 20 sec), Example 2 (IPA 10 sec), Comparative Example 1 (CB 20 sec), Comparative Example 3 (CB 10 sec) and the precursor film of an adduct of metal halide and guest molecule (PbI2-DMSO) in an organic halide solution for 10 seconds (MAI 10 sec), 20 seconds (MAI 20 sec), or 30 seconds (MAI 30 sec).

FIG. 6 shows a graph showing results of X-ray diffraction analysis of perovskite compound films fabricated by dipping the films fabricated in Example 1 and Comparative Example 1 in the organic halide solution for 30 seconds.
FIG. 7 shows scanning electron microscope (SEM) images of a precursor film (FIG. 7A), a porous metal halide film (FIG. 7B), and a perovskite compound film (FIG. 7C) fabricated in Example 3.
FIG. 8 shows scanning electron microscope (SEM) images of a porous metal halide film (FIG. 8A), and a perovskite compound film (FIG. 8B) fabricated in Example 4.
FIG. 9 shows a graph showing scattering intensity of a (101) plane according to a azimuthal angle, in GIWAXS spectrum of porous metal halide films fabricated in Comparative Example 4 and Example 3.
FIG. 10 shows a graph showing scattering intensity of a (110) plane according to a azimuthal angle, in GIWAXS spectrum of perovskite compound films fabricated in Comparative Example 4 and Example 3.
FIG. 11 shows X-ray diffraction patterns of the porous metal halide film fabricated in Example 3 and the porous metal halide film fabricated in Example 5.
FIG. 12 is an optical image of a perovskite compound film fabricated in Example 6.
FIG. 13 shows photoelectric conversion efficiency of each of twelve solar cells derived from a single perovskite compound film, in Example 10.
FIG. 14 shows a current density-voltage curve of one solar cell manufactured in Example 10.

## DETAILED DESCRIPTION OF EMBODIMENTS

Hereinafter, a porous organometal halide film of the present disclosure, a fabrication method thereof, and a fabrication method of an organometal halide film using the same are described in detail with reference to the accompanying drawings. In addition, the drawings to be described below are provided by way of example so that the idea of the present disclosure can be sufficiently transferred to those skilled in the art to which the present disclosure pertains. Therefore, the present disclosure may be implemented in many different forms, without being limited to the drawings to be described below. The drawings may be exaggerated in order to specify the spirit of the present disclosure. Here, unless technical and scientific terms used herein are defined otherwise, they have meanings generally understood by those skilled in the art to which the present disclosure pertains. Known functions and components that may obscure the gist of the present disclosure with unnecessary detail will be omitted.

In order to commercialize a device including an organometal halide film having a perovskite structure (hereinafter, referred to as a perovskite compound film), technology for simply and rapidly mass-producing the perovskite compound film in a large area should be preceded.

Accordingly, the present applicant proposed a fabrication method of a perovskite compound film capable of fabricating a thick perovskite compound film using a metal halide precursor film, wherein there was almost no change in thickness of the film before and after a reaction for forming a perovskite compound, and a dense film was capable of being fabricated.

However, even though a reaction speed (a conversion speed to the perovskite compound) is remarkably faster than that of a metal halide film itself, the metal halide precursor film itself is a dense film type with almost no pores, and thus it takes at least several tens of minutes for organic halide to be diffused into the metal halide precursor film so that the metal halide precursor film is completely converted to the perovskite compound film. The conversion process for several tens of minutes means that there is no choice but the perovskite compound film may be achieved by a batch process of one substrate unit in a commercial manner.

Meanwhile, the present applicant proposed a technology capable of rapidly fabricating a perovskite compound into a flat and dense film by a simple coating method, in detail, a solvent - non solvent coating technology in which a perovskite compound solution is applied, and before a coating film is dried, a non-solvent of the perovskite compound is in contact with the coating film.

The present applicant focused on the solvent - non solvent coating technology and the metal halide precursor technology that were developed by the present applicant, and found that by applying a non-solvent such as toluene or chlorobenzene to a metal halide precursor film (a coating film in a non-dried state), substitution between a guest molecule of the metal halide precursor and the non-solvent could be achieved, and a metal halide film having a porous structure could be fabricated by drying after the substitution between the guest molecule and the non-solvent.

The metal halide film having the porous structure may secure a reaction route with the organic halide, and time required for conversion into the perovskite compound may be remarkably shortened.

However, it was confirmed from preceding experiments that when the guest molecule was substituted and removed from the metal halide precursor film using the non-solvent, incomplete substitution occurred, and thus a relatively large amount of guest molecules remained, and particularly, there was a limit to large area treatment since uniform substitution of the entire metal halide precursor film was not achieved.

Therefore, in order to develop a method capable of uniformly substituting and removing the guest molecule effectively in the metal halide precursor film even in a large area, a long-term experiment was conducted using various

solvents.

It was confirmed through continued experiments that when using a polar protic solvent having strong binding force with a metal halide rather than a non-polar solvent (a non-solvent used in a solvent-non-solvent coating technology), the guest molecule was quickly and uniformly removed even though the metal halide precursor film was a thick film having a large area.

However, it was confirmed that even though the guest molecule was removed from the metal halide precursor film by using the polar protic solvent in which the perovskite compound was dissolved, unless a solvent satisfying a specific condition was used, even though the porous metal halide film was fabricated, it was not possible to achieve complete conversion into the perovskite compound due to preferred orientation of the fabricated metal halide film (metal halide grains or crystal grains in the film), and simultaneously a film quality of the perovskite compound film formed by the reaction was remarkably reduced, and thus the film was not practically usable.

Surprisingly, however, the present inventor found that when the guest molecule was removed using the polar protic solvent satisfying the specific condition, crystal orientation of the metal halide crystals constituting the porous metal halide film from which the guest molecule was removed was out of the (001) orientation and uniform. Further, in the case of a porous metal halide film having relatively random orientation out of the (001) orientation, even though it was a thick film, the film was completely converted into a perovskite compound film within a few to several tens of seconds, and simultaneously, the film was converted into a dense perovskite compound film with high-quality, and completed the present disclosure.

The present applicant provides a porous metal halide film, a fabrication method of the porous metal halide film, and a fabrication method of a perovskite compound film using the porous metal halide based on the above description.

The porous metal halide film according to the present disclosure satisfies Relational Expression 1 below:

(Relational Expression 1)

$$I(101)/I(001) \geq 0.5$$

in Relational Expression 1, I(101) is a diffraction intensity of a (101) plane in X-ray diffraction pattern using a Cu K$\alpha$ line of the porous metal halide film, and I(001) is a diffraction intensity of the (001) plane in the same X-ray diffraction pattern. Substantially, Relational Expression 1 may be 1 ≤ I(101)/I (001), more substantially, 5 ≤ I(101)/I(001), and further more substantially 10 ≤ I(101)/I (001) . In Relational Expression 1, the upper limit of I(101)/I(001) may be 50 or less.

As known to those skilled in the art relating the perovskite compound, when the perovskite compound film or the metal halide film is fabricated using a solution coating method, all films that are substantially fabricated regardless of a subsequent heat treatment exhibit (001) preferred orientation.

Relational Expression 1 may mean that the porous metal halide film according to an embodiment of the present disclosure is a metal halide film in which the (001) preferred orientation disappears, that is, a porous metal halide film having a non-(001) preferred orientation, a metal halide film having a random crystal orientation, and further, a porous metal halide film having the (101) preferred orientation.

Specifically, the X-ray diffraction pattern may be a pattern measured by a $\theta$-2$\theta$ method, using a Cu K$\alpha$ line and using a porous metal oxide film itself as a measurement sample. I(001) is a diffraction intensity (maximum value of a diffraction peak) by a (001) plane of a metal halide in the X-ray diffraction pattern of the porous metal oxide film, and I(101) is a diffraction intensity (maximum value of a diffraction peak) by a (101) plane of the metal halide in the X-ray diffraction pattern of the porous metal oxide film.

More specifically, I(001) may mean the maximum intensity of the diffraction peak positioned at 2$\theta$ of 11.5 to 13.5 in the X-ray diffraction pattern, and I(101) may mean the maximum intensity of the diffraction peak positioned at 2$\theta$ of 24.5 to 26.5 in the same X-ray diffraction pattern.

As described above, the metal halide film according to an embodiment of the present disclosure may satisfy 1 ≤ I(101)/I(001), substantially, 5 ≤ I(101)/I(001), and more substantially, 8 ≤ I (101)/I (001), and in Relational Expression 1, the upper limit of I(101)/I(001) may be 50 or less.

Specifically, the porous metal halide film according to an embodiment of the present disclosure may have the (101) preferred orientation based on the X-ray diffraction pattern described above, and simultaneously, in a grazing incidence wide angle X-ray scattering (GIWAXS) spectrum, the porous metal halide film may have a continuous scattering intensity in a azimuthal angle range of 10 to 80 degrees, and further, a continuous scattering intensity in a azimuthal angle range of 10 to 170 degrees, based on a scattering intensity of the (101) plane according to the azimuthal angle. In addition, together with the scattering pattern having a continuous scattering intensity in the GIWAXS spectrum, the porous metal halide film may have (101) preferred orientation better satisfying Relational Expressions 2 and 3 below:

(Relational Expression 2)

$$0.7 \leq I55/I10 \leq 1.5$$

I55 is an intensity at a azimuthal angle of 55 degrees based on a scattering intensity of a (101) plane according to the azimuthal angle, and I10 is an intensity at a azimuthal angle of 10 degrees based on the scattering intensity of the (101) plane according to the same azimuthal angle:

(Relational Expression 3)

$$0.7 \leq I55/I80 \leq 1.5$$

I55 is the same as defined in the Relational Expression 2, and I80 is an intensity at a azimuthal angle of 80 degrees based on the scattering intensity of the (101) plane according to the azimuthal angle.

The expression that the porous metal halide film has a continuous scattering intensity (diffraction intensity) at a azimuthal angle range of 10 to 80 degrees, and specifically 10 to 270 degrees and satisfies Relational Expressions 2 and 3 based on the scattering intensity of 55 degrees means that an omnidirectional diffraction of the (101) plane is generated, and a preferred orientation of the (001) plane that is oriented parallel to a surface of the film is not substantially exhibited. This is because when the (001) plane has the preferred orientation that is arranged in parallel to the surface of the film, an interplane angle between the (001) plane and the (101) plane is 55 degrees due to a unique crystal structure of the metal halide, the scattering intensity of the (101) plane according to the azimuthal angle on the GIWAXS spectrum has the maximum peak at 55 degrees.

As described above, the metal halide film may have the (101) preferred orientation based on the X-ray diffraction pattern, specifically the X-ray diffraction pattern and the GIWAXS spectrum, rather than the (001) preferred orientation.

When the metal halide film reacts with the organic halide to be converted into the perovskite compound, the orientation of the metal halide film greatly affects a rate of reaction (reaction into the perovskite compound) and/or the presence of unreacted residues (unreacted metal halide).

When the metal halide film has (101) preferred orientation, it is preferred since a very thick metal halide film having a thickness up to 100 μm may also be converted into the perovskite compound film completely without unreacted residues within 1 minute, specifically 5 to 50 seconds, more specifically 5 to 40 seconds, and further more specifically 10 to 40 seconds. In addition, it is known that in the case of a metal halide film having a (001) preferred orientation formed by a general solution coating method, a perovskite compound film having a (001) preferred orientation is also fabricated by a reaction with an organic halide. However, in the case of a metal halide film having a (101) preferred orientation, it is more preferred since the film is capable of being converted into a substantially completely random perovskite compound film in which the preferred orientation disappears.

In the porous metal halide film according to an embodiment of the present disclosure, the GIWAXS spectrum of the porous metal halide film may be measured at an incident angle of 0.3 degrees using an X-ray having a wavelength of $\lambda$ = 1.0688 Å (11.6 keV) and a beam size of 150 μm (h) × 120 μm (v) (full width half maximum: FWHM), wherein the diffraction pattern may be detected using a two-dimensional region detector, a detector may be positioned at 246.4118 mm from a sample for GIWAXS measurement, and a measurement area of the sample may be 0.1 $mm^2$ to 20 $mm^2$.

The porous metal halide film according to an embodiment of the present disclosure may be a porous film having porosity due to open pores, and may be a porous film satisfying Relational Expression 4 below:

(Relational Expression 4)

$$Ap \geq 0.05$$

In Relational Expression 4, Ap means an area occupied by pores per unit area of the porous metal halide film. In other words, the Relational Expression 4 means an area of the pores per unit area based on the surface of the porous metal halide film. Experimentally, in the scanning electron microscope image obtained by observing the surface of the porous metal halide film using the SEM, Ap may be a value obtained by dividing the sum of areas occupied by the pores into the observation area (the surface area of the porous metal halide film on the scanning electron microscope image), and in order to obtain a reliable result in actual measurement, a scale bar of the scanning electron microscope image is preferably about 1 cm = 0.5 to 5 μm.

In the metal halide film having the porous structure, due to open pores, a material movement path of the organic

halide may be stably secured, and simultaneously a reaction area between the metal halide and the organic halide may also be greatly improved, thereby completing the conversion into the perovskite compound within a few to several tens of seconds.

Further, as described later, the guest molecule may be removed from the metal halide precursor film to thereby generate pores, and the guest molecule of the metal halide precursor film is uniformly removed by the polar protic solvent in a state where separate energy (heat, light, vibration, etc.) is not applied, thereby generating pores, and thus the pores satisfying Ap of Relational Expression 4 may be homogeneously distributed throughout the film, and most of the pores (open pores) may be positioned at an interface or triple point between metal halide crystal grains (or grains).

In addition, an average size (diameter) of the metal halide crystal grain (or grain) of the metal halide precursor film may be 0.1 to 1 μm, specifically 0.2 to 0.6 μm.Here, an average size (diameter) of the pore (open pore) may be a size corresponding to 5 to 50%, specifically 5 to 30% of the average size of the metal halide crystal grains. Experimentally, the average size of the metal halide crystal grain and the average size of the pore may be measured using the scanning electron microscope (SEM) image obtained by observing the surface of the porous metal halide film using the scanning electron microscope, respectively. In detail, the average size of the metal halide crystal grain and the average size of the pore may correspond to a diameter value of a circle calculated by converting a value, which is obtained by dividing the total area occupied by the metal halide or pores into the number of metal halide crystal grains or the number of pores, into a circle having the same area in the scanning electron microscope (SEM) image obtained by observing the surface of the porous metal halide film, respectively.

The metal halide film according to an embodiment of the present disclosure is a porous film having porosity due to open pores, wherein the Ap may be substantially 0.08 or more, more substantially 0.10 or more, or further more practically 0.14 or more. In view of a fabrication method, when the Ap is 0.14, the guest molecule of the metal halide precursor film is substantially completely removed. As Ap indicates the porosity due to the removal of the guest molecule of the metal halide precursor film, a content of the guest molecule of the metal halide precursor film may affect the upper limit of Ap. As a specific and substantial example, the upper limit of Ap of the metal halide film may be 0.30 or less, substantially 0.20 or less, and more substantially 0.18 or less.

The metal halide film according to an embodiment of the present disclosure may further satisfy Relational Expression 5 below:

(Relational Expression 5)

$$|Ap(center)-Ap(corner)|/Ap(center) * 100 \leq 10\%$$

in Relational Expression 5, Ap (center) means an area occupied by pores per unit area in a central region of a porous metal halide film based on a size of 2 inches by 2 inches, and Ap (corner) means an area occupied by pores per unit area in an edge region of the porous metal halide film having the same size as above.

Here, in the porous metal halide film based on the size of 2 inches by 2 inches, a central region may mean an area within a radius of 100 μm from the center of gravity, and an edge region may mean an area within 200 μm from the edge of the film.

Relational Expression 5 is an index showing uniformity of the pores per surface position in the metal halide film having a large area. That is, the Relational Expression 5 means that Ap in the central region of the film and Ap in the edge region of the film are substantially the same as each other.

Substantially, the metal halide film according to an embodiment of the present disclosure may satisfy **|Ap(center)-ApCcorner)|/Ap(center)** *100≤ 8%, **|Ap(center)-Ap(corner)|/Ap(center)** * 100 ≤ 5%, wherein the lower limit of **|Ap(center)-Ap(corner)|/Ap(center)** may be substantially zero.

When presenting the removal of the guest molecule represented by Relational Expression 5, that is, the uniformity of the pores, in a different manner, the metal halide film according to an embodiment of the present disclosure may satisfy Relational Expression 5' below:

(Relational Expression 5')

$$\sigma(Ap_9) \leq 0.05$$

in Relational Expression 5', $\sigma(Ap_9)$ means a standard deviation of Ap which is an area occupied by pores per unit area at the center of each region (i.e., a standard deviation calculated from Ap of the first region to Ap of the ninth region), on the first to ninth regions (virtual equally divided regions) in which the porous metal halide film based on a size of 2 inches by 2 inches is divided into nine regions.

In addition, in Relational Expression 5', $\sigma(Ap_9)$ is an index indicating uniformity of pores in the metal halide film having a large area, and is an index indicating uniformity of the removal of the guest molecule. When $\sigma(Ap_9)$ is 0.05 or less, it means that the porosity is uniform throughout the entire area of the metal halide film having a large area.

The metal halide film according to an embodiment of the present disclosure has the above-described porosity and the above-described orientation, and thus unlike the conventional 2-step method, even though it is a very thick metal halide film, the metal halide film may be converted into a pure and dense high-quality perovskite compound film without remaining unreacted metal halide in an extremely short reaction time of within 1 minute, specifically in several seconds to several tens of seconds.

Specifically, the conventional 2-step method is a technology of forming a stacked body of a metal halide film and an organic halide film, and then applying heat to thereby be converted into a perovskite compound film. However, a heat treatment temperature is limited to a very low temperature (generally 140 °C or less) at which the perovskite compound film is not thermally damaged, the metal halide film already has a dense film form, and the perovskite compound is generated based on an interface of the metal halide film and the organic halide film, and thus material movement should be performed through an intermediate layer of the perovskite compound. For this reason, in the conventional 2-step method, when the metal halide film is thick, the metal halides are not all converted into the perovskite compound, and thus there is a limitation on the thickness of the perovskite compound film to be fabricated and the metal halide film to be used, and there is a technical limitation in that a metal halide film having a thickness of 1 $\mu$m or less is generally used.

However, since the metal halide film according to an embodiment of the present disclosure has the above-described porosity and the above-described orientation, there is no substantial limitation on the thickness of the film that is capable of being converted into the perovskite compound without unreacted residues. As an example, even though a film has a thickness of 2 $\mu$m, the film may be converted into a pure and dense high-quality perovskite compound film without remaining unreacted metal halide in an extremely short reaction time of within 1 minute or less, specifically several seconds to several tens of seconds. Accordingly, the thickness of the metal halide film may be appropriately adjusted in consideration of the use of the perovskite compound film to be converted. However, the thickness of the metal halide film is not substantially limited, but for example, may be 1 to 1000 $\mu$m, and 50 to 300 $\mu$m as a practical example in consideration of the use of a solar cell light absorbing layer.

The metal halide film according to an exemplary embodiment of the present disclosure may be reacted with the organic halide to be converted into the organometal halide having a perovskite structure (perovskite compound), thereby fabricating the organometal halide (perovskite compound). Here, the porosity of the metal halide film may provide an inflow path of the organic halide while simultaneously increasing the reaction area to enable extremely rapid conversion, and further may prevent deterioration of the film quality by the volume increase that occurs when the metal halide is converted into the organometal halide. That is, the pores present in the metal halide film may absorb volume expansion generated upon conversion into the organometal halide, and thus an organometal halide film having a dense and smooth surface may be fabricated. Even in view of the conversion into the organometal halide film (perovskite compound film) having a dense and smooth surface from the metal halide film, together with the provision of a stable inflow path and the increase in the reaction area, the Ap may be 0.05 to 0.20, substantially 0.08 to 0.20, more substantially 0.10 to 0.20, and further more substantially 0.14 to 0.20, and even more substantially 0.14 to 0.18.

In the metal halide film according to an embodiment of the present disclosure, the metal halide may be a compound of a metal cation and a halogen anion.

Specifically, the metal halide may satisfy Chemical Formula of $MX_2$ (M is a divalent metal ion and X is a halogen ion). Here, the halogen ion may be one or two or more selected from $I^-$, $Br^-$, $F^-$, and $Cl^-$. Here, examples of the M which is the divalent metal ion may include one or two or more metal ions selected from $Cu^{2+}$, $Ni^{2+}$, $Co^{2+}$, $Fe^{2+}$, $Mn^{2+}$, $Cr^{2+}$, $Pd^{2+}$, $Cd^{2+}$, $Ge^{2+}$, $Sn^{2+}$, $Pb^{2+}$, and $Yb^{2+}$.

Otherwise, the metal halide may satisfy Chemical Formula of $(M_{1-a}N_a)X_2$, wherein M is a divalent metal ion, N is at least one doping metal ion selected from a monovalent metal ion and a trivalent metal ion, a is a real number of $0 < a \leq 0.1$, and X is a halogen ion. Here, the halogen ion may be one or two or more selected from $I^-$, $Br^-$, $F^-$, and $Cl^-$. Here, the monovalent metal ion, which is the doping metal ion, may include an alkali metal ion. Examples of the alkali metal ion may include one or two or more selected from $Li^+$, $Na^+$, $K^+$, $Rb^+$, and $Cs^+$ ions. Here, examples of the trivalent metal ion which is a doping metal ion may include one or two or more selected from $Al^{3+}$, $Ga^{3+}$, $In^{3+}$, $Tl^{3+}$, $Sc^{3+}$, $Y^{3+}$, $La^{3+}$, $Ce^{3+}$, $Fe^{3+}$, $Ru^{3+}$, $Cr^{3+}$, $V^{3+}$, and $Ti^{3+}$ ions.

Otherwise, the metal halide may satisfy Chemical Formula of $(N^1{}_{1-b}N^2{}_b)X_2$, wherein $N^1$ is a monovalent metal ion, $N^2$ is a trivalent metal ion, b is a real number of $0.4 \leq b \leq 0.6$ and X is a halogen ion). Here, the halogen ion may be one or two or more selected from $I^-$, $Br^-$, $F^-$, and $Cl^-$. Here, the monovalent metal ion ($N^1$) may include an alkali metal ion, and specific examples of the alkali metal ion may include one or two or more ions selected from $Li^+$, $Na^+$, $K^+$, $Rb^+$ and $Cs^+$ ions. Here, examples of the trivalent metal ion may include one or two or more selected from $Al^{3+}$, $Ga^{3+}$ , $In^{3+}$, $Tl^{3+}$, $Sc^{3+}$, $Y^{3+}$, $La^{3+}$, $Ce^{3+}$, $Fe^{3+}$, $Ru^{3+}$, $Cr^{3+}$, $V^{3+}$, and $Ti^{3+}$ ions.

The present disclosure includes a fabrication method of the porous metal halide film as described above.

The fabrication method of a metal halide film according to the present disclosure may include: contacting a

precursor film (adduct layer) containing an adduct of metal halide and guest molecule with a polar protic solvent satisfying Relational Expression 6 below to fabricate a porous metal halide film:

(Relational Expression 6)

$$\delta_h(gm) < \delta_h(pa)$$

in Relational Expression 6, $\delta_h$(gm) is a hydrogen bonding component ($\delta_h$, $MPa^{0.5}$) in a Hansen solubility parameter of the guest molecule, and $\delta_h$(pa) is a hydrogen bonding component ($\delta_h$, $MPa^{0.5}$) in a Hansen solubility parameter of the polar protic solvent.

In the precursor film containing the adduct of metal halide and guest molecule, the adduct of metal halide and guest molecule may be a compound including the guest molecule (hereinafter, referred to GM) together with a metal cation and a halogen anion constituting the perovskite compound.

In detail, the adduct of metal halide and guest molecule may be a compound in which the metal halide of the metal cation and the halogen anion constituting the perovskite compound; and the guest molecule are non-covalently bonded to each other. More specifically, the adduct of metal halide and guest molecule may be a compound in which the metal halide; and the guest molecule including oxygen, nitrogen, or oxygen and nitrogen which include non-covalent electron pairs, are non-covalently bonded to each other. Structurally, in the adduct of metal halide and guest molecule, the guest molecule may be interposed between layers of the metal halide having a layered structure, or may be combined with the metal halide to form a crystal phase different from the metal halide.

As a specific example, in the adduct of metal halide and guest molecule, the guest molecule (GM) that is non-covalently bonded to the metal halide may be a monomolecule to a polymer including oxygen, nitrogen, or oxygen and nitrogen which include non-covalent electron pairs. As an example, the guest molecule that is non-covalently bonded to the metal halide may be any molecule known to form a compound by a non-covalent bond with the metal halide, such as dimethylsulfoxide (DMSO), N-methyl-2-pyrrolidone (NMP), 2,2'-bipyridine, 4,4'-bipyridine-N,N'-dioxide, pyrazine, 1,10-phenanthroline, 2-methylpyridine, poly(ethylene oxide), or the like.

When describing the adduct of metal halide and guest molecule based on the Chemical Formula, the adduct of metal halide and guest molecule may satisfy Chemical Formula of $MX_2(GM)_n$, wherein M is a divalent metal ion, X is a halogen ion, GM is a guest molecule that non-covalently binds to $MX_2$, and n is a real number of 0.5 to 50). Here, the divalent metal ion and the halogen ion are similar or identical to those described above in the porous metal halide film. Furthermore, since an amount of pores generated by the removal of the guest molecule (GM) is almost the same as an amount of volume increase at the time of conversion into the perovskite compound (amount of volume increase at the time of conversion from the metal halide film to the perovskite compound), in view of prevention of the volume change at the time of conversion into the perovskite compound, it is preferred that the GM is a guest single molecule that is non-covalently bonded to $MX_2$ and includes oxygen, nitrogen, or oxygen and nitrogen, and n is 0.5 to 5, and specifically, n is 0.5 to 2.

Alternatively, the adduct of metal halide and guest molecule may satisfy Chemical Formula of $(M_{1-a}N_a)X_2$, wherein M is a divalent metal ion, N is at least one doping metal ion selected from a monovalent metal ion and a trivalent metal ion, a is a real number of $0 < a \leq 0.1$, X is a halogen ion, GM is a guest molecule that is non-covalently bonded to $(M_{1-a}N_a)X_2$, and n is a real number of 0.5 to 50. Here, the divalent metal ion, the doping metal ion, and the halogen ion are similar or identical to those described above in the porous metal halide film. In addition, in view of prevention of the volume change at the time of conversion into the perovskite compound, it is preferred that the GM is a guest single molecule that is non-covalently bonded to $(M_{1-a}N_a)\ X_2$ and includes oxygen, nitrogen, or oxygen and nitrogen, and n is 0.5 to 5, and specifically, n is 0.5 to 2.

Alternatively, the adduct of metal halide and guest molecule may satisfy Chemical Formula $(N^1_{1-b}N^2_b)\ X_2\ (GM)_n$, wherein $N^1$ is a monovalent metal ion, $N^2$ is a trivalent metal ion, b is a real number of $0.4 \leq b \leq 0.6$, X is a halogen ion, GM is a guest molecule that is non-covalently bonded to $(N^1_{1-b}N^2_b)\ X_2$, and n is a real number of 0.5 to 50. Here, the monovalent metal ion, the trivalent metal ion, and the halogen ion are similar or identical to those described above in the porous metal halide film. In addition, in view of prevention of the volume change at the time of conversion into the perovskite compound, it is preferred that the GM is a guest single molecule that is non-covalently bonded to $(N^1_{1-bN}{}^2_b)X_2$ and includes oxygen, nitrogen, or oxygen and nitrogen, and n is 0.5 to 5, and specifically, n is 0.5 to 2.

As a practical example of the adduct of metal halide and guest molecule that is non-covalently bonded to the metal halide and includes oxygen, nitrogen, or oxygen and nitrogen, the guest molecule may be a solvent that dissolves the metal halide (a solvent of a metal halide), and the adduct of metal halide and guest molecule may be a solvate including the metal halide and the solvent that dissolves the metal halide. The solvate may mean a higher order compound formed between a molecule or an ion of a solute (metal halide) and a molecule or an ion of a solvent.

As a practical example of the solvate based on Chemical Formula, the adduct of metal halide and guest molecule

may satisfy Chemical Formula $MX_2(GM)_n$, wherein M is a divalent metal ion, X is a halogen ion, GM is a guest molecule that is non-covalently bonded to the metal halide $MX_2$ and is a solvent molecule that includes oxygen, nitrogen, or oxygen and nitrogen and dissolves the metal halide, and n is a real number of 0.5 to 5, and specifically n is 0.5 to 2. Alternatively, the adduct of metal halide and guest molecule may satisfy Chemical Formula of $(M_{1-a}N_a)\ X_2\ (GM)_n$, wherein M is a divalent metal ion, N is at least one doping metal ion selected from a monovalent metal ion and a trivalent metal ion, a is a real number of $0 < a \leq 0.1$, X is a halogen ion, GM is a guest molecule that is non-covalently bonded to a metal halide of $(M_{1-a}N_a)X_2$ and is a solvent molecule that includes oxygen, nitrogen, or oxygen and nitrogen and dissolves the metal halide, and n is a real number of 0.5 to 5, and specifically n is 0.5 to 2. Alternatively, the adduct of metal halide and guest molecule may satisfy Chemical Formula $(N^1_{1-b}N^2_b)\ X_2\ (GM)_n$, wherein $N^1$ is a monovalent metal ion, $N^2$ is a trivalent metal ion, b is a real number of $0.4 \leq b \leq 0.6$, X is a halogen ion, GM is a guest molecule that is non-covalently bonded to the metal halide $(N^1_{1-b}N^2_b)X_2$ and is a solvent molecule that includes oxygen, nitrogen, or oxygen and nitrogen and dissolves the metal halide, and n is a real number of 0.5 to 5, and specifically n is 0.5 to 2.

A specific example of the guest molecule which is a solvent of the metal halide may include one or two or more materials selected from dimethylsulfoxide (DMSO) and N-methyl-2-pyrrolidone (NMP). More specifically, the adduct of metal halide and guest molecule may be a compound of metal halide and dimethylsulfoxide.

The adduct of metal halide and guest molecule may be fabricated or purchased to be used. As a specific and non-limiting example, a metal halide precursor may be prepared by dropping a solution in which a metal halide (or metal cation and a halogen anion) and a guest molecule are dissolved into a non-solvent.

More specifically, when the metal halide precursor is a solvate, an adduct of metal halide and guest molecule may be fabricated by including a step of preparing an adduct solution by dissolving a metal halide or a metal cation and a halogen ion according to a stoichiometric ratio of the metal halide in a solvent as a guest molecule; a step of dropping the adduct solution into the non-solvent; and a step of recovering and drying a solid phase obtained by the dropping. Here, the non-solvent may mean an organic solvent that does not dissolve the metal halide and does not have miscibility with the solvent. Here, the expression in which the non-solvent does not dissolve the metal halide may mean an organic solvent in which a solubility of the metal halide is less than 0.1 M, specifically less than 0.01 M, and more specifically less than 0.001 M at 20°C under 1 atm. The expression that the non-solvent does not have miscibility with the solvent dissolving the metal halide (the guest molecule when the metal halide is a solvent compound) may mean that when the non-solvent is mixed with the solvent of the metal halide solution, layer separation is achieved in a static state in which physical agitation is not performed. An example of the non-solvent may include a non-polar organic solvent. An example of the non-polar organic solvent may include one or two or more organic solvents selected from pentane, hexene, cyclohexene, 1,4-dioxane, benzene, toluene, triethylamine, chlorobenzene, ethylamine, ethylether, chloroform and 1,2-dichlorobenzene, etc., but the present disclosure is not limited to the non-solvent.

More specifically, when the adduct of metal halide and guest molecule is the solvate, the adduct of metal halide and guest molecule may be fabricated by a method including a step of preparing an adduct solution by dissolving a metal halide or a metal cation and a halogen anion according to a stoichiometric ratio of the metal halide in a solvent as a guest molecule; a step of dropping the adduct solution into the non-solvent; a step of separating and recovering a solid phase obtained by the dropping; a step of heat-treating the separated and recovered solid phase to control a relative molar ratio of the guest molecule relative to the metal halide in the solid phase. That is, by separating and recovering the solid phase formed by dropping the adduct solution into the non-solvent, a first adduct of metal halide and guest molecule may be fabricated, and by controlling a molar ratio of the guest molecule relative to the metal halide of the first adduct of metal halide and guest molecule through heat treatment, a second adduct of metal halide and guest molecule containing the guest molecule having a controlled content (n is a real number of 0.5 to 5, specifically 0.5 to 2 in the above Chemical Formula) may be fabricated. A heat treatment temperature may be appropriately controlled in consideration of a material of the guest molecule. However, the heat treatment is preferably performed at a temperature of 100°C or less, specifically 50 to 80°C, and more specifically 60 to 80°C, in consideration that the metal halide and the guest molecule are weakly bonded by the non-covalent bond.

Independently, the precursor film may be fabricated by directly applying a solution containing a metal halide and a guest molecule (an adduct solution) itself on the substrate.

In detail, the fabricating of the precursor film may include a step of forming the precursor film containing an adduct of metal halide and guest molecule by applying the adduct solution containing the metal halide and the guest molecule on the substrate.

The adduct solution may be a solution in which the adduct of metal halide and guest molecule is dissolved in a solvent, or a solution in which the metal halide and the guest molecule are dissolved in a solvent. More specifically, the adduct solution in which the adduct of metal halide and guest molecule is dissolved in the solvent may be applied to form the precursor film, or the adduct solution containing the metal halide, the guest molecule, and the solvent may be applied to form the adduct of metal halide and guest molecule while simultaneously fabricating the precursor film. That is, a previously prepared adduct of metal halide and guest molecule may be used, or unlike this, preparation of the adduct of metal halide and guest molecule and formation of the precursor film may be simultaneously performed. When

the previously prepared adduct of metal halide and guest molecule is used, it is preferred since a molar concentration of the adduct of metal halide and guest molecule in the adduct solution may be increased. When the adduct solution containing the metal halide, the guest molecule, and the solvent is used to form the adduct of metal halide and guest molecule while simultaneously fabricating the precursor film, it is preferred since the preparation process is simpler.

Specifically, the adduct solution containing the metal halide; or the metal cation and the halogen anion according to a stoichiometric ratio of the metal halide; and the solvent that dissolves the guest molecule and the metal halide may be prepared, then applied on the substrate on which the precursor film is to be formed, and thus the precursor film containing the adduct of metal halide and guest molecule may be fabricated. Here, the solvent contained in the adduct solution may be any conventional solvent dissolving the metal halide. A specific example of the solvent of the adduct solution may include N,N-dimethylformamide (DMF), gamma-butyrolactone (GBL), N,N-dimethylacetamide, a mixed solvent thereof, or the like, but is not limited thereto.

The adduct solution may contain 1 to 2.5 mol of guest molecule relative to 1 mol of metal halide, and preferably 1 to 1.5 mol of guest molecule relative to 1 mol of metal halide. When the adduct solution has the above-described molar ratio between the metal halide and the guest molecule, it is preferred since when the guest molecule is removed by the polar protic solvent to be described later, it is possible to fabricate a porous metal halide film having a (101) preferred orientation in which I (101)/I (001) is 5 or more, specifically 10 or more, and more specifically 15 or more.

A metal halide concentration in the adduct solution may be 0.3 g/ml to 1.0 g/ml, but is not limited thereto.

The adduct solution may be applied by a coating method or a printing method commonly used for application of a liquid phase or a dispersed phase. As a specific example, the application of the adduct solution may be performed by dip coating, spin coating, casting, slot die, bar coater, gravure (gravure offset), offset-reverse offset, doctor blade, screen printing, inkjet printing, electrostatic hydraulic printing, micro contact printing, imprinting, or the like, but is not limited thereto.

A thickness of the precursor film may be appropriately selected in consideration of the use, and may be, as a specific example, 1 $\mu$m to 1000 $\mu$m, but is not limited thereto.

The precursor film in contact with the polar protic solvent may be a coating film in which a part of the solvent remains or a precursor film in a dry state in which the solvent is volatilized and removed. That is, the precursor film in contact with the polar protic solvent may be a film in which a part of the solvent remains or a solid phase (dried) film. However, when the precursor film (coating film) in an undried state is in contact with the polar protic solvent, there is a risk that the substitution and removal of the guest molecule by the polar protic solvent may not be performed rapidly, and thus there is a risk that a porous film having uniform pores may not be formed. Thus, the precursor film is more preferably the solid phase film.

Thus, as a form of the adduct of metal halide and guest molecule, a metal halide porous film satisfying the above-described Ap by the removal of the guest molecule contained in the precursor film is fabricated. Further, the precursor film containing the adduct of metal halide and guest molecule is preferably a dried and solid phase film so that the metal halide porous film having uniform pores may be fabricated even in a large area.

Here, in drying the precursor film, substantial drying may be completed while simultaneously performing the above-described application of the adduct solution or immediately after the application of the adduct solution, and thus the drying step may not be separately performed. However, when the drying step is performed according to the process needs, the drying may be performed through low-temperature drying, blowing, or the like, in which a binding of the guest molecule bound to the metal halide is broken and the guest molecule may not be volatilized and removed. In the case of blowing, the drying may be performed by weakly blowing the film with an inert gas gun such as argon, or the like, an air gun, or the like. In the case of the low-temperature drying, a drying temperature may be appropriately changed in consideration of the material of the guest molecule, but the drying of the precursor film may be performed stably from room temperature to 70°C, more stably from room temperature to 50°C, and the most stably, at room temperature. Accordingly, the fabrication method of a metal halide film according to a preferred embodiment of the present disclosure may include: contacting a dried (solid phase) precursor film (adduct layer) containing an adduct of metal halide and guest molecule with a polar protic solvent satisfying Relational Expression 6 below to fabricate a porous metal halide film.

As described above, the fabrication method of the porous metal halide film according to an embodiment of the present disclosure may include: a) forming the precursor film containing an adduct of metal halide and guest molecule by applying an adduct solution containing the metal halide, the guest molecule, and a solvent on a flexible substrate; and b) forming the porous metal halide film by contacting the precursor film with the polar protic solvent satisfying Relational Expression 6 below:

(Relational Expression 6)

$$\delta_h(gm) < \delta_h(pa)$$

in Relational Expression 6, $\delta_h$(gm) is a hydrogen bonding component ($\delta_h$, $MPa^{0.5}$) in a Hansen solubility parameter of the guest molecule, and $\delta_h$(pa) is a hydrogen bonding component ($\delta_h$, $MPa^{0.5}$) in a Hansen solubility parameter of the polar protic solvent.

Due to the polar protic solvent having the hydrogen bonding component stronger than that of the guest molecule, the guest molecule bonded to the metal halide may be very quickly and effectively removed, and even when the precursor film is a thick film having a large area, the guest molecule may be uniformly and rapidly removed throughout the entire area of the precursor film.

In order to rapidly and effectively remove and uniformly remove the guest molecule from the precursor film while simultaneously preventing the metal halide in the film from being damaged by the polar protic solvent, the polar protic solvent preferably satisfies Relational Expression 6' below, and further satisfies Relational Expression 6" below. That is, when using the polar protic solvent having the hydrogen bonding component that is excessively stronger than that of the guest molecule, a problem in that the metal halide may be etched by the polar protic solvent may occur, and thus the polar protic solvent preferably satisfies Relational Expression 6' below, and further satisfies Relational Expression 6" below:

(Relational Expression 6')

$$4.0 \leq \delta_h(gm) - \delta_h(pa) \leq 15.0$$

in Relational Expression 6', $\delta_h$(gm) and $\delta_h$(pa) are the same as in Relational Expression 6.

(Relational Expression 6'')

$$4.0 \leq \delta_h(gm) - \delta_h(pa) \leq 10.0$$

in Relational Expression 6", $\delta_h$(gm) and $\delta_h$(pa) are the same as in Relational Expression 6.

In the fabrication method of the metal halide film according to an embodiment of the present disclosure, it is preferred that the polar protic solvent may further satisfy Relational Expressions 7 and 8 below:

(Relational Expression 7)

$$0.8 \leq \delta_t(pa)/\delta_t(gm) \leq 1.1$$

in Relational Expression 7, $\delta_t$(gm) is a Hansen solubility parameter ($MPa^{0.5}$) of the guest molecule, and $\delta_t$ (pa) is a Hansen solubility parameter ($MPa^{0.5}$) of the polar protic solvent, and

(Relational Expression 8)

$$7.0 \leq \delta_p(gm) - \delta_p(pa) \leq 15.0$$

in Relational Expression 8, $\delta_p$(gm) is a dispersion component ($\delta_p$, $MPa^{0.5}$) in a Hansen solubility parameter of the guest molecule, and $\delta_p$(pa) is a dispersion component ($\delta_p$, $MPa^{0.5}$) in a Hansen solubility parameter of the polar protic solvent.

The polar protic solvent satisfying Relational Expressions 7 and 8 is preferred since the polar protic solvent acts as a solvent for the guest molecule but acts as a non-solvent for the metal halide, thereby selectively removing the guest molecule in the adduct of metal halide and guest molecule without adversely affecting the metal halide.

In order to quickly and stably substitute and remove the guest molecule bonded to the metal halide from the precursor film and to stably act as the non-solvent for the metal halide and as the solvent for the guest molecule, the polar protic solvent preferably further satisfies the above-described Relational Expression 6', substantially Relational Expression 6", together with Relational Expressions 7 and 8.

In the fabrication method of the metal halide film according to an embodiment of the present disclosure, it is preferred that the polar protic solvent may further satisfy Relational Expression 9 below:

(Relational Expression 9)

$$0.5 \leq Vm(pa)/Vm(gm) \leq 1.15$$

in Relational Expression 9, $V_m$(pa) is a molar volume of the polar protic solvent and $V_m$(gm) is a molar volume of the guest molecule.

Relational Expression 9 means that the polar protic solvent has a size substantially similar to or smaller than a size of the guest molecule bonded to the metal halide. The polar protic solvent having the size is preferred since it may penetrate extremely easily into an inner part of the precursor film from the surface thereof while removing the guest molecule bonded to the metal halide, and thus the guest molecule may be more rapidly and homogeneously removed, and further, a volume change may not be caused during the process of removing the guest molecule.

Further, when the guest molecule is removed from the precursor film using the polar protic solvent satisfying Relational Expression 6 (preferably, Relational Expression 6', and more preferably Relational Expression 6''), Relational Expression 7, and Relational Expression 8, a porous metal halide film that does not exhibit the (100) preferred orientation may be fabricated, the guest molecule may be substantially and completely removed without damaging the metal halide by an extremely short contact, i.e., within 1 minute, and the pores satisfying the above-described porosity of Ap may be homogeneously formed in the film. At the same time, in an extremely short time of within 1 minute, the fabricated porous metal halide film may be converted into a substantially pure perovskite compound film in which unreacted metal halide does not remain, may be converted into a dense perovskite compound film, and may be converted into a perovskite compound film having random orientation.

In the fabrication method according to an embodiment of the present disclosure, the polar protic solvent satisfying the above-described Relational Expression 6, preferably Relational Expressions 6 to 8, and more preferably Relational Expressions 6 to 9 is preferably an alcohol-based solvent. The alcohol-based solvent is advantageous for commercialization process construction, fabrication, and management since it does not have strong toxicity, and is easily supplied, and has high volatility.

Those skilled in the art may select and use an appropriate polar protic solvent satisfying the above-described Relational Expressions for each guest molecule based on the guest molecule of the adduct of metal halide and guest molecule and the Hansen solubility parameter known for each material (on the basis of 25°C, and as an example, a known value by Charles Hansen, "Hansen Solubility Parameters: A User's Handbook" CRC Press (2007), "The CRC Handbook and Solubility Parameters and Cohesion Parameters," Allan F. M. Barton (1999), etc., or a value calculated by commercially available software such as Molecular Modeling Pro, Dynacomp Software, or the like).

As a specific and non-limiting example, dimethylsulfoxide (DMSO) may be included as a representative guest molecule of the adduct of metal halide and guest molecule. When the guest molecule is dimethylsulfoxide, the polar protic solvent in which the hydrogen bonding component ($MPa^{0.5}$) in the Hansen solubility parameter is more than 10.2 according to Relational Expression 6, preferably the hydrogen bonding component is 14.2 to 25.2 according to Relational Expression 6', and more preferably the hydrogen bonding component is 14.2 to 20.2 according to Relational Expression 6" may be in contact with the precursor film to remove the guest molecule.

As a more preferable example, when the guest molecule is dimethylsulfoxide, the polar protic solvent in which the Hansen solubility parameter (total Hansen solubility parameter, $MPa^{0.5}$) is 21.38 to 29.37, and the dispersion component ($MPa^{0.5}$) in the Hansen solubility parameter is 1.4 to 9.4 according to Relational Expressions 7 and 8 may be in contact with the precursor film to remove the guest molecule.

An example of an alcohol-based polar protic solvent having the hydrogen bonding component of 14.2 to 20.2, the Hansen solubility parameter of 21.38 to 29.37, and the dispersion component of 1.4 to 9.4 and being advantageous for commercialization process may include 2-ethoxyethanol, phenoxyethanol, 2-butanol, 2-furanmethanol, 1-butanol, 2-methylpropyl alcohol, isopropylalcohol(2-Propanol), 2-methoxymethanol, 1-propanol and/or ethanol, etc.

As a more preferable example, when the guest molecule is dimethylsulfoxide, and when satisfying Relational Expression 9 together with Relational Expressions 6", 7 and 8, the polar protic solvent in which a molar volume ($cm^3$/mol, based on 25°C) is 35.65 to 81.99 according to Relational Expression 9, the hydrogen bonding component is 14.2 to 20.2, the Hansen solubility parameter is 21.38 to 29.37, and the dispersion component is 1.4 to 9.4 may be in contact with the precursor film to remove the guest molecule.

An example of an alcohol-based polar protic solvent having the hydrogen bonding component of 14.2 to 20.2, the Hansen solubility parameter of 21.38 to 29.37, the dispersion component of 1.4 to 9.4 and the molar volume of 35.65 to 81.99 and being advantageous for commercialization process may include isopropylalcohol, 2-methoxymethanol, 1-propanol and/or ethanol, etc.

The contact between the precursor film and the polar protic solvent may be performed by commonly used liquid-phase application methods such as dipping (dipping of a precursor film with a polar protic solvent), spray application (spraying of a polar protic solvent), spin coating, etc.

However, when the precursor film is in contact with the polar protic solvent, the contact is preferably performed in a state in which external energy such as heat or light is not applied. This is to prevent pores that are generated by the removal of the guest molecule in the precursor film from healing and disappearing by the applied energy.

However, if necessary, a heat treatment step for more rapidly removing the solvent remaining on the film selectively when the precursor film is in contact with the polar protic solvent, or after the precursor film is in contact with the polar protic solvent, and for improving crystallinity of the metal halide may be performed, wherein the heat treatment step (drying step or annealing step) is preferably performed within a range in which porosity healing due to grain growth of the metal halide does not occur. As an example, this heat treatment step may be performed at a temperature of from 30 to 70°C, and stably at a temperature of from 30 to 50°C.

A contact time between the precursor film and the polar protic solvent may vary to some extent depending on a specific method for contacting. However, even by the contact time of within 1 minute, specifically 1 to 50 seconds, more specifically 5 to 30 seconds, and further more specifically, 5 to 15 seconds, the guest molecule of the precursor film may be substantially and completely removed. That is, when the guest molecule is removed by using the polar protic solvent satisfying the above-described condition, even though it is a precursor film in a thick film form having a large area, the porous metal oxide film in which pores are stably and uniformly formed throughout the entire region may be fabricated by a short contact for several seconds to several tens of seconds.

In addition, as described above, the porous metal oxide film in which pores are uniformly formed by the removal of the guest molecule may be converted into the perovskite compound film completely without unreacted residues in a remarkably short time of within 1 minute, specifically 5 to 50 seconds, more specifically 5 to 40 seconds, even more specifically 10 to 40 seconds.

By these characteristics, the porous metal oxide film, and further, the perovskite compound film may be fabricated by a continuous process including a roll-to-roll process, etc.

As described above, the fabrication method of a porous metal halide film according to an embodiment of the present disclosure may include a step of forming a precursor film containing an adduct of metal halide and guest molecule on a flexible substrate; and a step of removing a guest molecule by applying a polar protic solvent to the precursor film, wherein the step of forming the film and the step of removing the guest molecule may be a continuous process, and the continuous process may include a roll-to-roll process. That is, the step of forming the film may be performed by the roll-to-roll process, and the step of removing the guest molecule may be performed continuously by the same roll-to-roll process. The roll-to-roll process may include an unwinder for unwinding a film-shaped flexible substrate wound in a roll form, a stage for performing a process on the flexible substrate, and a rewinder for rewinding the flexible substrate into a roll after the process is performed, and may be performed by using a conventional roll-to-roll process apparatus equipped with several transport rollers for transporting the flexible substrate therebetween.

The step of forming the film (the above-described step a)) and the step of removing the guest molecule (the above-described step b)) may be continuously performed by performing a first stage of printing the above-described adduct solution on the flexible substrate unwound by the unwinder, and drying (including natural drying) a printed matter, performing a second stage of applying (including spraying) the above-described polar protic solvent to the precursor film formed on the flexible substrate by the first stage, or dipping the precursor film with the polar protic solvent, followed by drying (including natural drying or drying by blowing), and then performing a single roll-to-roll process in which the film is wound into a roll again by the rewinder.

The printing of the adduct solution on the flexible substrate, i.e., the step of forming the film may be performed by a printing process such as slot die, bar coater, gravure (gravure offset), offset-reverse offset, doctor blade, screen printing, inkjet printing, electrostatic hydraulic printing, micro contact printing, imprinting, or the like. Here, according to the specific printing method, in order to satisfy printability to be required, the adduct solution may further include an additive such as a viscosity modifier (thickener), if necessary. Here, the viscosity modifier is preferably a material dissolved in a polar protic solvent, and specific and advantageous examples of the viscosity modifier dissolved in the polar protic solvent may include polyethylene glycol, Polyvinylpyrrolidone, ethyl cellulose, etc. These examples of the viscosity modifier are preferred since they are easily dissolved in a solvent that dissolves the metal halide (or the adduct of metal halide and guest molecule), and at the same time, they are capable of being removed simultaneously when the guest molecule is removed using the above-described polar protic solvent.

A fabrication method of an organometal halide film (perovskite compound film) is described.

The fabrication method of the perovskite compound film according to an exemplary embodiment of the present disclosure includes a fabrication method of an organometal halide film having a perovskite structure using the porous metal halide film as described above.

In detail, the fabrication method of a perovskite compound film according to an embodiment of the present disclosure includes d) contacting the porous metal halide film with an organic halide to fabricate the organometal halide film having a perovskite structure (a perovskite compound film).

The fabrication method of the perovskite compound film according to an exemplary embodiment of the present disclosure includes a fabrication method of an organometal halide film having a perovskite structure using the fabrication

method of the porous metal halide film as described above.

In detail, the fabrication method of the perovskite compound film according to an embodiment of the present disclosure includes c) fabricating a porous metal halide film by the fabrication method as described above; and d) contacting the porous metal halide film with an organic halide to fabricate the organometal halide film having a perovskite structure (a perovskite compound film).

In the fabrication method of the perovskite compound film according to an embodiment of the present disclosure, the fabrication of the porous metal halide film in step d) and the porous metal halide film in step c) may correspond to the fabrication method of the porous metal halide film or the porous metal halide film described above, and thus the fabrication method of the perovskite compound film according to an embodiment of the present disclosure includes all the contents of the fabrication method of the porous metal halide film and the fabrication method of the porous metal halide film described above.

The contact between the porous metal halide film and the organic halide may be a contact between the porous metal halide film and the organic halide solution. Here, the organic halide solution may contain an organic halide and a solvent that dissolves the organic halide.

The contact between the porous metal halide film and the organic halide solution may be performed by applying the organic halide solution to the porous metal halide film or by dipping the porous metal halide film with the organic halide solution. Due to pores of the metal halide film, a material movement path may be stably secured, a reaction area in contact with the organic halide may also be increased, and the metal halide film may have (101) orientation that is capable of being converted into the perovskite compound very rapidly, and thus the conversion into a pure perovskite compound film without unreacted residues may be achieved within a remarkably short time of within 1 minute, specifically 5 to 50 seconds, more specifically 5 to 40 seconds, and further more specifically 10 to 40 seconds, even by a simple room temperature contact.

As a specific and practical example, the perovskite compound film may be formed by applying the organic halide solution on the porous metal halide film, or by dipping the porous metal halide film into the organic halide solution. Here, the solvent that dissolves the organic halide may be one or more selected from tert-butyl alcohol, 2-butanol, isobutyl alcohol, 1-butanol, isopropanol, 1-propanol, ethanol, and methanol, but is not limited thereto.

A concentration of the organic halide in the organic halide solution may be at least 5 mg/ml, and may be preferably 35 mg/ml, substantially 35 to 80 mg/ml, and more substantially 40 mg/ml to 70 mg/ml so as to be completely converted into the perovskite compound without the metal halide residues in a short contact time of within 1 minute, specifically several seconds to several tens of seconds.

After the contact between the porous metal halide film and the organic halide solution is performed, drying may be performed, if necessary. The drying may be performed by any drying method as long as the solvent is easily volatilized and removed without damaging the perovskite compound film formed by the contact with the organic halide solution. As a specific example, the drying may be performed using a low-temperature heat treatment, blowing, or the like. Specifically, when the blowing is used, drying may be performed by weakly blowing the film with an inert gas gun such as argon gun, an air gun, or the like. As a specific example of the low-temperature drying, the drying may be performed by heating the film at a low temperature of 50 to 90°C. However, when the solvent is highly volatile, since natural drying may occur during or immediately after the contacting process, the drying may be selectively performed, if necessary.

After step d), the fabrication method of the perovskite compound film according to an embodiment of the present disclosure may further include annealing the perovskite compound film fabricated in step d). The annealing treatment is useful when it is desired to improve crystallinity of the perovskite compound in the film or, in addition, to obtain a perovskite compound film formed of more coarse crystal grains. The annealing may be performed in a temperature range in which the perovskite compound is not thermally damaged, specifically, in a temperature range of 95 to 120°C, and the annealing may be performed for several tens to several hundreds of seconds, specifically, for 10 to 100 seconds, but the annealing time is not limited thereto.

The organic halide may satisfy Chemical Formula of AX, wherein A is a monovalent organic cation and is one or two cations selected from ammonium group cation and amidinium group cation, and X is one or two or more halogen anions selected from $Cl^-$, $Br^-$, $F^-$ and $I^-$. As described above, A may be an amidinium group ion, an organic ammonium ion or an amidinium group ion and an organic ammonium ion. The organoammonium ion may satisfy Chemical Formula of $(R_1\text{-}NH_3^+)X$, wherein $R_1$ is C1-C24 alkyl, C3-C20 cycloalkyl or C6-C20 aryl and X is one or two or more halogen ions selected from $Cl^-$, $Br^-$, $F^-$ and $I^-$ or Chemical Formula of $(R_2\text{-}C_3H_3N_2^+\text{-}R_3)X$, wherein $R_2$ is C1-C24 alkyl, C3-C20 cycloalkyl or C6-C20 aryl, $R_3$ is hydrogen or C1-C24 alkyl, and X is one or two or more halogen ions selected from $Cl^-$, $Br^-$, $F^-$, and $I^-$. As a non-limiting and specific example, $R_1$ may be C1-C24 alkyl, preferably C1-C7 alkyl, and more preferably, methyl. $R_2$ may be C1-C24 alkyl, $R_3$ may be hydrogen or C1-C24 alkyl, preferably $R_2$ may be C1-C7 alkyl, $R_3$ may be hydrogen or C1-C7 alkyl, and more preferably, $R_2$ may be methyl, and $R_3$ may be hydrogen. As a non-limiting and specific example, the organic halide may be $CH_3NH_3I$, $CH_3NH_3Cl$, or $CH_3NH_3Br$. $R_1$ or $R_2$ and $R_3$ may be suitably selected in consideration of the use of the perovskite compound film, that is, a design of a wavelength band of a light to be absorbed when used as a light absorbing layer of a solar cell, a design of an emission wavelength band when used as a light emitting layer

of a light emitting device, and an energy bandgap and a threshold voltage when used as a semiconductor device of a transistor, etc.

The amidinium group ion may satisfy Chemical Formula below:

[Chemical Formula]

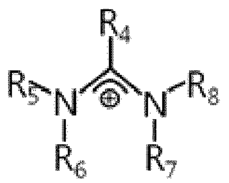

in Chemical Formula, $R_4$ to $R_8$ are each independently hydrogen, C1-C24 alkyl, C3-C20 cycloalkyl or C6-C20 aryl. As a non-limiting and specific example, in consideration of absorption of sunlight, $R_4$ to $R_8$ may be each independently hydrogen, amino or C1-C24 alkyl, specifically hydrogen, amino or C1-C7 alkyl, and more specifically, hydrogen, amino or methyl. More specifically, $R_4$ may be hydrogen, amino or methyl, and $R_5$ to $R_8$ may be hydrogen. As a specific and non-limiting example, the amidinium group ion may include formamidinium ion ($NH_2CH=NH_2^+$) , acetamidinium ion ($NH_2C$ ($CH_3$) $=NH_2^+$) or guamidinium ion ($NH_2C$ ($NH_2$) $=NH_2^+$). The specific example of the amidinium group ion is provided in consideration of the use of the light absorber of the solar cell. This is because, as described above, a size of the unit cell of the perovskite compound is related to a band gap, and it is possible to have a band gap energy of 1.5 to 1.1 eV that is suitable for utilization as a solar cell in a small unit cell size. However, $R_2$ to $R_6$ may be suitably selected in consideration of the use of the perovskite compound film, that is, a design of a wavelength band of a light to be absorbed when used as a light absorbing layer of a solar cell, a design of an emission wavelength band when used as a light emitting layer of a light emitting device, and an energy bandgap and a threshold voltage when used as a semiconductor device of a transistor, etc.

As described above, the monovalent organic ion (A) of the organic halide may be a monovalent organic ammonium ion represented by $R_1$-$NH_3^+$ or $R_2$-$C_3H_3N_2^+$-$R_3$ described above, the amidinium group described above based on Chemical Formula, or the organic ammonium ion and the amidinium group ion.

When the monovalent organic ion includes both an organic ammonium ion and an amidinium group ion, the organic halide may satisfy Chemical Formula of $A'_{1-x}A_xX$, wherein A is a monovalent organic ammonium ion described above, and A' is an amidinium group ion described above, X is one or two or more halogen ions selected from $I^-$, $Br^-$, $F^-$, and $Cl^-$, and x is a real number of $0 < x < 1$, preferably a real number of $0.05 \leq x \leq 0.3$. When assuming that a total number of moles of monovalent organic cations is 1 and containing an amidinium group ion of 0.7 to 0.95 and an organic ammonium ion of 0.3 to 0.05, it is possible to fabricate a perovskite compound film capable of absorbing light in a very wide wavelength band, enabling faster exciton migration and separation, and faster photoelectron and photohole migration.

The porous metal halide fabricated from the precursor film containing the adduct of metal halide and guest molecule and/or the organic halide in contact with the porous metal halide may contain two or more different halogen ions from each other. When the metal halide and/or the organic halide contain(s) two or more different halogen ions, it is possible to fabricate a perovskite compound film in which occurrence of a undesired different phase is prevented and stability of the crystal phase is enhanced, by the different halogen ions.

Specifically, the porous metal halide film and/or the organic halide may include two or more ions selected from iodine ion, chlorine ion and bromine ion, and preferably, iodine ion and bromine ion. In detail, the porous metal halide film and/or the organic halide may contain the halogen anion having a composition containing 0.7 to 0.95 iodine ions and 0.3 to 0.05 bromine ions when assuming that a total number of moles of halogen anions contained in the perovskite compound film is 1, based on the composition of the perovskite compound film to be fabricated. Specifically, as to the total halogen anion contained in the porous metal halide and the organic halide, based on the composition of the perovskite compound film of $AMX_3$ (A is the same as A of the organic halide, M is the same as M of the metal halide, and $X_3$ is the sum of X derived from the organic halide and the metal halide), X of $AMX_3$ may contain the halogen anion so as to contain iodine ions of 0.7 to 0.95 and bromine ions of 0.3 to 0.05. A relative molar ratio between the iodine ions and the bromine ion, that is, a molar ratio of 0.7 to 0.95 mol of iodine ions : 0.3 to 0.05 mol of bromine ions is a molar ratio capable of promoting formation of a single crystal phase and improving crystallinity, and improving moisture resistance of the perovskite compound film.

However, the kind and composition of the halogen ion contained in the porous metal halide film and the organic halide, respectively, may be different from each other, and as described above, the metal halide film and the organic halide may have different halogen ions and different compositions from each other so that X contains 0.7 to 0.95 of iodine ions and 0.3 to 0.05 of bromine ions based on the composition $AMX_3$ of the finally obtained perovskite compound

film.

In the fabrication method of the perovskite compound film according to an embodiment of the present disclosure, step a) and step b), step c) and step d), or step a) to step d) may be performed by a continuous process since the metal halide film may be stably converted into the perovskite compound within several seconds to several tens of seconds even at room temperature. Here, the continuous process may include a roll-to-roll process.

Specifically, the fabrication method of a perovskite compound film may include a step of forming a precursor film containing an adduct of metal halide and guest molecule on a flexible substrate; a step of removing a guest molecule by applying a polar protic solvent to the precursor film; and a conversion step of contacting a porous metal halide film obtained by removing the guest molecule with an organic halide solution to be converted into a perovskite compound film, wherein the step of forming the film, the step of removing the guest molecule, and the conversion step may be a continuous process including a roll-to-roll process. That is, the step of forming the film may be performed by the roll-to-roll process, and the step of removing the guest molecule may be performed continuously by the same roll-to-roll process, and the conversion step into the perovskite compound film may be performed continuously by the same roll-to-roll process.

In this case, fabrication of the perovskite compound may be performed continuously by performing the first stage and the second stage described above, performing a third stage of applying (including spraying) the above-described organometal halide solution to the porous metal oxide film formed on the flexible substrate or dipping the porous metal oxide film with an organometal halide solution, followed by drying (including natural drying), and then performing a single roll-to-roll process in which the film is wound into a roll again by the rewinder. Here, after the third stage is performed, if necessary, rinse (washing) for removing the organic halide remaining in the perovskite compound film in an unreacted state may be further performed, and annealing may be further performed to improve crystallinity of the perovskite compound.

As a specific example of the use, the perovskite compound film fabricated by the fabrication method according to an embodiment of the present disclosure may be used for a transistor, a light emitting element, a sensor light, an electronic element, an optical element, or a sensor light including the conventional perovskite compound as a constituent element.

That is, the fabrication method of the perovskite compound film according to an embodiment of the present disclosure may correspond to a step of forming a perovskite compound film in an electronic device, an optical element, or a sensor light, that includes the conventional perovskite compound as constituent element thereof.

In this aspect, the substrate may serve not only as a support for physically supporting the precursor film (or the perovskite compound film) but also may be formed with other constituent elements in addition to the perovskite compound film in the electronic element, the optical element or the sensor light, that includes the conventional perovskite compound as a constituent element thereof. In addition, after the perovskite compound film is fabricated, in consideration of the well-known structure of the device including the conventional perovskite compound as a constituent element thereof, a step of forming other constituent element positioned on an upper part of the perovskite compound film may be further performed.

In an example of a solar cell in which the perovskite compound film is provided as a light absorber, the step of fabricating a perovskite compound film may be performed, and steps of forming a second charge transport layer (for example, a hole transport layer) that transfers charges complementary to the first charge transport layer (for example, an electron transport layer), and a second electrode, which is a counter electrode of the first electrode, may be further performed.

That is, in an example of the solar cell in which the perovskite compound film is provided as the light absorber, a substrate may include a first electrode; and a first charge transport layer that are previously formed on a physical support; and a first charge transport layer may be an electron transport layer or a hole transport layer.

The first electrode is not particularly limited as long as it is commonly used in the art, and may be any transparent conductive electrode as long as it is ohmic-bonded to the first charge transport layer which is the electron transport layer or the hole transport layer. As a specific example, the transparent conductive electrode may be any one or two or more selected from fluorine-doped tin oxide (FTO), indium-doped tin oxide (ITO), ZnO, carbon nanotube, graphene, and a combination thereof.

Here, the first electrode may be formed on a transparent substrate (support), which is a rigid substrate (support) or a flexible substrate (support), by a deposition process such as physical vapor deposition or chemical vapor deposition, and specifically may be formed by thermal evaporation. As an example of the transparent substrate (support), the rigid substrate may be a glass substrate, or the like, and the flexible substrate may be polyethylene terephthalate (PET), polyethylene naphthalate (PEN), polyimide (PI), polycarbonate (PC), polypropylene (PP), triacetylcellulose (TAC), polyethersulfone (PES), or the like.

Next, a step of forming a first charge transport layer, for example, an electron transport layer, on the first electrode may be performed. Specifically, the electron transport layer may be an inorganic material and may include a metal oxide. The electron transport layer may be a flat metal oxide layer, a metal oxide layer having surface irregularities, a metal oxide layer having a complex structure in which a nanostructure (including metal oxide particles, nanowires

and/or nanotubes) of a homogeneous or heterogeneous metal oxide is formed on a surface of a single metal oxide film having a thin film form, a dense metal oxide layer or a porous metal oxide layer. As a practical example, the first charge transport layer may be a stacked body of a dense film and a porous film or may be a dense film, and more specifically, may be a dense metal oxide film or may be a stacked body of a dense metal oxide film and a meso-porous metal oxide film.

First, a step of forming a dense metal oxide layer on the first electrode may be performed. The dense metal oxide layer may be formed through a deposition process such as physical vapor deposition or chemical vapor deposition, or may be formed by applying metal oxide nanoparticles, followed by thermal treatment.

The first charge transport layer (for example, the electron transport layer) may be the dense metal oxide layer. However, according to a design of the device, the first charge transport layer (for example, the electron transport layer) may be a laminate of the dense metal oxide layer and the porous metal oxide layer.

When the electron transport layer is the laminate of the dense metal oxide layer and the porous metal oxide layer, a step of forming the porous metal oxide layer on the dense metal oxide layer may be performed, wherein the porous metal oxide layer may include metal oxide particles, and may have an open porous structure by an empty space between these particles.

In one example, the porous metal oxide layer may be fabricated by applying a slurry containing metal oxide particles on a dense metal oxide layer, and drying and heat treating the applied slurry layer. The applying of the slurry may be performed by any one or two or more methods selected from screen printing, spin coating, bar coating, gravure coating, blade coating, and roll coating, etc.

Main factors influencing the specific surface area and the open pore structure of the porous metal oxide layer are an average particle size of the metal oxide particle and a heat treatment temperature. The average particle size of the metal oxide particle may be 5 to 500 nm, and the heat treatment may be performed at 200 to 600°C in the air, but the average particle size of the metal oxide particle and the heat treatment are not necessarily limited thereto.

A thickness of a first charge carrier may be, for example, 50 nm to 10 $\mu$m, specifically 50 nm to 5 $\mu$m, more specifically 50 nm to 1 $\mu$m, and even more specifically 50 to 800 nm, but is not necessarily limited thereto.

The metal oxide of the first charge transport layer may be used without particular limitation as long as it is a metal oxide conventionally used for photocharge transfer in a solar cell. Specifically, for example, the metal oxide may be any one or two or more selected from Ti oxide, Zn oxide, In oxide, Sn oxide, W oxide, Nb oxide, Mo oxide, Mg oxide, Zr oxide, Sr oxide, Yr oxide, La oxide, V oxide, Al oxide, Y oxide, Sc oxide, Sm oxide, Ga oxide, In oxide, SrTi oxide, and a combination thereof, etc.

In the above-described method, the step of forming a support-phase precursor film on which the first charge transport layer (for example, the electron transport layer) and the electrode are formed and the step of removing the guest molecule of the precursor film by the solvent may be performed. Then, a step of converting the metal halide film into the perovskite compound film by contact with the organic halide may be performed. Thus, a laminate of the transparent substrate (support), the first electrode, the first charge transport layer (for example, an electron transport layer), and the perovskite compound film may be fabricated.

After the perovskite compound film is formed, a step of forming a second charge transport layer (for example, a hole transport layer) and a step of forming a second electrode may be performed on the perovskite compound film.

The step of forming the hole transport layer may be performed by applying a solution containing an organic hole transport material (hereinafter, referred to as an organic hole transport solution) to cover an upper portion of the perovskite compound film, followed by drying. The applying may be performed by spin coating, and a thickness of the hole transport layer may be 10 to 500 nm, but is not necessarily limited thereto.

The solvent used for forming the hole transport layer may be any solvent as long as it dissolves the organic hole transport material and does not chemically react with the perovskite compound and a substance of the electron transport layer. As an example, the solvent used for forming the hole transport layer may be a non-polar solvent. As a substantial example, the solvent may be any one or two or more selected from toluene, chloroform, chlorobenzene, dichlorobenzene, anisole, xylene, and a hydrocarbon-based solvent having 6 to 14 carbon atoms.

The organic hole transport material used in the step of forming the hole transport layer may be a monomolecular organic hole transport material to a polymer organic hole transport material, but is not limited thereto. Non-limiting examples of the monomolecular organic hole transport material to low molecular organic hole transport material may include one or two or more materials selected from pentacene, coumarin 6 (3-(2-benzothiazolyl)-7-(diethylamino)coumarin), ZnPC (zinc phthalocyanine), CuPC (copper phthalocyanine), TiOPC (titanium oxide phthalocyanine), spiro-MeOTAD (2,2',7,7'-tetrakis(N,N-p-dimethoxyphenylamino)-9,9'-spirobifluorene), F16CuPC (copper(II) 1,2,3,4,8,9,10,11,15,16,17,18,22,23,24,25-hexadecafluoro-29H,31H-phthalocyanine), subPc (boron subphthalocyanine chloride), and N3(cis-di(thiocyanato)-bis(2,2'-bipyridyl-4,4'-dicarboxylic acid)-ruthenium(II)), but the monomolecular organic hole transport material to low molecular organic hole transport material is not limited thereto.

Non-limiting examples of the polymer organic hole transport material may include one or two or more materials selected from P3HT (poly[3-hexylthiophene]), MDMO-PPV (poly[2-methoxy-5-(3',7'-dimethyloctyloxyl)]-1,4-phenylene vinylene), MEH-PPV (poly[2-methoxy-5-(2''-ethylhexyloxy)-p-phenylene vinylene]), P30T (poly(3-octyl thiophene)), POT

(poly(octyl thiophene)), P3DT (poly(3-decyl thiophene)), P3DDT (poly(3-dodecyl thiophene), PPV (poly(p-phenylene vinylene)), TFB (poly(9,9'-dioctylfluorene-co-N-(4-butylphenyl)diphenyl amine), Polyaniline, Spiro-MeOTAD ([2,22',7,77'-tetrkis (N,N-di-p-methoxyphenyl amine)-9,9,9'-spirobi fluorine]), PCPDTBT (Poly[2,1,3-benzothiadiazole-4,7-diyl[4,4-bis(2-ethylhexyl-4H- cyclopenta [2,1-b:3,4-b']dithiophene-2,6-diyl]], Si-PCPDTBT (poly[(4,4'-bis(2-ethylhexyl)dithieno[3,2-b:2',3'-dlsilole)-2,6-diyl-alt-(2,1,3-benzothiadiazole)-4,7-diyl]), PBDTTPD (poly((4,8-diethylhexyloxyl) benzo([1,2-b:4,5-b']dithiophene)-2,6-diyl)-alt-((5-octylthieno[3,4-c]pyrrole-4,6-dione)-1,3-diyl)), PFDTBT (poly[2,7-(9-(2-ethylhexyl)-9-hexyl-fluorene)-alt-5,5-(4',7, -di-2-thienyl-2',1', 3'-benzothiadiazole)]), PFO-DBT (poly[2,7-.9,9-(dioctyl-fluorene)-alt-5,5-(4',7'-di-2-.thienyl-2', 1',3'-benzothiadiazole)]), PSiFDTBT (poly[(2,7-dioctylsilafluorene)-2,7-diyl-alt-(4,7-bis(2-thienyl)-2,1,3-benzothiadiazole)-5,5'-diyl]), PSBTBT (poly[(4,4'-bis(2-ethylhexyl)dithieno[3,2-b:2',3'-d]silole)-2,6-diyl-alt-(2,1,3-benzothiadiazole)-4,7-diyl]), PCDTBT (Poly [[9'-(1-octylnonyl)-9H-carbazole-2,7-diyl]-2,5-thiophenediyl-2,1,3-benzothiadiazole-4,7-diyl-2,5-thiophenediyl]), PFB (poly(9,9'-dioctylfluorene-co-bis (N,N'-(4,butylphenyl))bis(N,N'-phenyl-1,4-phenylene)diamine), F8BT (poly(9,9'-dioctylfluorene-co-benzothiadiazole), PEDOT (poly(3,4-ethylenedioxythiophene)), PEDOT:PSS (poly(3,4-ethylenedioxythiophene) poly(styrenesulfonate)), PTAA (poly(triarylamine)), Poly(4-butylphenyl-diphenyl-amine), and a copolymer thereof, but the polymer organic hole transport material is not limited thereto.

In the step of forming the hole transport layer, the organic hole transport solution may further contain any one or two or more additives selected from TBP (tertiary butyl pyridine), LiTFSI (lithium bis(trifluoro methanesulfonyl)imide), HTFSI (bis(trifluoromethane) sulfonimide), 2,6-lutidine and tris(2-(1H-pyrazol-1-yl)pyridine)cobalt(III), etc. By adding the additive to the organic hole transport solution, a fill factor, or a short-circuit current or an open-circuit voltage may be increased. Here, the additive may be added in an amount of 0.05 to 100 mg per 1 g of the organic hole transport material contained in the organic hole transport solution, but the amount of the additive is not necessarily limited thereto.

Next, after the step of forming the hole transport layer is performed, a step of forming a second electrode may be performed. The second electrode may be formed by any conventional metal deposition method used in a semiconductor process. As an example, the second electrode may be formed through a deposition process such as physical vapor deposition, chemical vapor deposition, or the like, and specifically, may be formed by thermal evaporation. The second electrode, which is a counter electrode of the first electrode, may be any electrode material that is conventionally used in the field of solar cells. As a practical example, the second electrode may include any one or two or more materials selected from gold, silver, platinum, palladium, copper, aluminum, carbon, cobalt sulfide, copper sulfide, nickel oxide, and a combination thereof, etc.

As described above, the present disclosure includes not only a fabrication method of a perovskite compound film but also a fabrication method of a device including the perovskite compound film as a constituent element. As a typical example, the present disclosure includes a perovskite-based solar cell including a perovskite compound film as a light absorbing layer.

Here, when the second charge transport layer is an organic hole transport layer or an organic electron transport layer, the perovskite compound film may be fabricated by the above-described roll-to-roll process using a substrate on which a first electrode and a first charge transport layer are formed on a transparent flexible film as a flexible substrate of the roll-to-roll process, and then the step of forming a second charge transport layer may be performed by a continuous roll-to-roll process. In addition, the step of forming a second electrode may be performed by the continuous roll-to-roll process. Further, when the first charge transport layer is also an organic hole transport layer or an organic electron transport layer based on an organic material, the first charge transport layer may be fabricated by a roll-to-roll process using a transparent flexible film on which a first electrode is formed as a flexible substrate of the roll-to-roll process, and then fabrication of the porous metal halide film, conversion into the perovskite compound film, and fabrication of the second charge transport layer may be performed by the continuous roll-to-roll process. Further, when the second electrode is formed by applying a dispersion of a conductive nanostructure, such as carbon nanotubes or graphene, the formation of the second electrode may also be performed by the continuous roll-to-roll process.

(Example 1)

$PbI_2$ powder (0.6 g) (lead iodide, 99%) purchased from Sigma-Aldrich Co. was added and dissolved in a mixed solvent including 0.2 ml of methylsulfoxide (DMSO) (2.17 mol of DMSO relative to 1 mol of $PbI_2$) and 0.8 ml of N,N-dimethylformamide (DMF) to prepare an adduct solution.

The prepared adduct solution was injected at a time into the center of rotation on an FTO substrate (glass substrate coated with fluorine-containing tin oxide, FTO: F-doped $SnO_2$, 8 ohms/$cm^2$, Pilkington), followed by spin coating for 30 seconds at a rotation speed of 3000 rpm, thereby fabricating a dried precursor film (having a film thickness of 0.3 $\mu$m).

The fabricated precursor film was dipped in isopropyl alcohol (anhydrous 2-propanol, IPA, Sigma-Aldrich) for 20 seconds, and then the film was separated and recovered, and dried at room temperature by weakly blowing with argon gun, thereby fabricating a porous metal halide film from which the guest molecule (DMSO) was removed.

Then, the fabricated porous metal halide film was dipped in an organic halide solution (40 mg of $NH_3CH_3I$ / 1

ml of isopropyl alcohol) for 10 seconds, 20 seconds, or 30 seconds, respectively, to fabricate a perovskite compound film.

(Comparative Example 1)

After the precursor film fabricated in the same manner as in Example 1 was dipped in chlorobenzene for 20 seconds, the film was separated and recovered, and dried at room temperature by weakly blowing with argon gun, thereby fabricating a metal halide film of Comparative Example 1. Then, a perovskite compound film (a perovskite compound film of Comparative Example 1) was fabricated by contacting the fabricated metal halide film of Comparative Example 1 with an organic halide solution in the same manner as in Example 1.

(Comparative Example 2)

The precursor film fabricated in the same manner as in Example 1 was heat-treated at 100 °C for 10 minutes to fabricate a metal halide film (a metal halide film of Comparative Example 2) from which the guest molecule (DMSO) was removed by heat energy.

FIG. 1 shows results of X-ray diffraction analysis of the precursor film fabricated in Example 1 ($PbI_2$-DMSO in FIG. 1), the porous metal halide film fabricated in Example 1 (IPA in FIG. 1), and the metal halide film fabricated in Comparative Example 2 (heat treatment in FIG. 1), respectively.

It could be appreciated from the X-ray diffraction pattern of the precursor film of FIG. 1 that the adduct film of metal halide and guest molecule, which was a solvate of $PbI_2$ and DMSO, was fabricated. Further, from the results shown in FIG. 1, it could be appreciated that the DMSO, which is the guest molecule, was removed from the precursor film by heat treatment or by contact with isopropyl alcohol, and diffraction peaks of the adduct of metal halide and guest molecule disappeared and diffraction peaks of the metal halide ($PbI_2$) were observed.

In addition, as appreciated from results of Comparative Example 2 in FIG. 1, it could be appreciated that when the guest molecule was removed by the heat treatment, a metal halide film having (001) preferred orientation like the related art was fabricated, and further, it was confirmed that in Comparative Example 1 using chlorobenzene, the metal halide film having (001) orientation was fabricated even though the orientation was weaker than that of the heat treatment. However, it could be appreciated that when the guest molecule was removed using a polar protic solvent of isopropyl alcohol, a metal halide film having (101) preferred orientation was fabricated. Here, a ratio of I(101)/I(001) of the metal halide film fabricated in Example 1 was 8.4.

FIG. 2 shows scanning electron microscope images showing a surface of the fabricated precursor film (FIG. 2(a)), a surface of the porous metal halide film fabricated in Example 1 (FIG. 2(c)), and a surface of the metal halide film fabricated in Comparative Example 2 (FIG. 2(c)).

As appreciated from FIG. 2, it could be appreciated that a dense precursor film was fabricated, and when the guest molecule was removed from the precursor film by heat treatment, a metal halide film in which pores were healed by grain growth or densification and residual pores were rarely present was fabricated. However, when the guest molecule was removed by contacting with isopropyl alcohol, it could be appreciated that the porous metal halide film having uniform pores was fabricated, and that pores were present uniformly in a thickness direction as appreciated in a cross-sectional image.

According to Relational Expression 4, a ratio of an area occupied by pores per unit area of the surface of the porous metal halide film fabricated in Example 1 was measured, and as a result, Ap of the porous metal halide film fabricated in Example 1 was 0.17.

FIG. 3 shows scanning electron microscope (SEM) images of the surface of the porous metal halide film fabricated in Example 1 (IPA in FIG. 3) and the surface of the porous metal halide film fabricated by using chlorobenzene in Comparative Example 1 (CB in FIG. 3). As appreciated in FIG. 3, a porosity of the film fabricated in Comparative Example 1 was significantly lower than that of the film of Example 1. As a result, it could be appreciated that when the porous metal halide film was fabricated according to an embodiment of the present disclosure, the guest molecule was substantially and completely removed even by contact for about 20 seconds, whereas in Comparative Example 1, the dipping process for 20 seconds was not able to remove the guest molecule sufficiently.

In addition, Ap was measured in each of the central region and the edge region of the surface of the porous metal halide film having a size of 2 inches by 2 inches that was fabricated in Example 1, and as a result, it was confirmed that a change between Ap values according to Relational Expression 5 was only 3%. However, in the film fabricated in Comparative Example 1, the porosity was significantly different for each surface region, and the change between Ap values according to Relational Expression 5 was confirmed to be 13%.

As a result of X-ray diffraction analysis of the film fabricated in Comparative Example 1, the metal halide film from which the guest molecule was removed by using chloroform was also confirmed to have strong (001) preferred orientation, which was similar to Comparative Example 2 where the guest molecule was removed by the heat treatment.

It was also confirmed that, a film substantially similar to the film fabricated by the dipping was obtained even

when the precursor film was contacted with the solvent by spin coating without dipping the precursor film (isopropyl alcohol or chlorobenzene) with the solvent in Example 1 and Comparative Example 1.

(Example 2)

A porous metal halide film was fabricated by performing the same method as in Example 1, except for dipping the precursor film in isopropyl alcohol for 10 seconds. Then, the fabricated porous metal halide film was dipped in an organic halide solution (40 mg of $NH_3CH_3I$ / 1 ml of isopropyl alcohol) for 10 seconds, 20 seconds, or 30 seconds, respectively, in the same manner as in Example 1, thereby fabricating a perovskite compound film.

(Comparative Example 3)

A metal halide film and a perovskite compound film were fabricated in the same manner as in Comparative Example 1 except that the metal halide film was fabricated by dipping the precursor film in chlorobenzene for 10 seconds instead of 20 seconds.

FIG. 4 shows optical microscope images obtained by dipping each metal halide film of Example 1 (IPA 20 sec in FIG. 4), Example 2 (IPA 10 sec in FIG. 4), the precursor film ($PbI_2$-DMSO in FIG. 4), Comparative Example 1 (CB 20 sec in FIG. 4), and Comparative Example 3 (CB 10 sec in FIG. 4) in an organic halide solution (10 mg of $NH_3CH_3I$ /1 ml of isopropyl alcohol) for 10 seconds, 20 seconds, or 30 seconds, respectively, to be converted into the perovskite compound, and observing the film converted by a dipping time of the organic halide solution (10 sec, 20 sec, 30 sec) .

As appreciated in FIG. 4, it could be confirmed that the metal halide films of Examples 1 and 2 in which the guest molecule was removed by contact with isopropyl alcohol for 10 seconds or 20 seconds were converted into the perovskite compounds uniformly throughout the entire region, and it could be appreciated that the metal halide films were substantially completely converted into the perovskite compound even by dipping in the organic halide solution for only 10 to 30 seconds.

However, as appreciated in FIG. 4, it could be appreciated that the precursor film was hardly converted into the perovskite compound even when it was dipped in the organic halide solution for 30 seconds, and it could be appreciated that when using chlorobenzene, the guest molecule was non-uniformly removed for each position, and thus the conversion into the perovskite compound was also very non-uniform, and that a large amount of non-converted metal halide remained even after 30 seconds of dipping.

FIG. 5 shows ultraviolet-visible (UV-Vis) light absorption spectrum of each perovskite film fabricated in Example 1 (IPA 20 sec in FIG. 5), Example 2 (IPA 10 sec in FIG. 5), the precursor film ($PbI_2$-DMSO in FIG. 5), Comparative Example 1 (CB 20 sec in FIG. 5), Comparative Example 3 (CB 10 sec in FIG. 5) for each dipping time of the organic halide solution.

As appreciated in FIG. 5, it could be appreciated that in Example 1 (the IPA 20 sec), an absorption spectrum was almost irrelevant to the contact time with the organic halide solution, and in Example 2 (IPA 10 sec), as the contact time with the organic halide solution was increased, an absorption rate was increased by a very small amount. Accordingly, it could be appreciated that the guest molecule (DMSO) of the precursor film was substantially and completely removed only by dipping the precursor film in isopropyl alcohol for 10 seconds, and all of the fabricated porous metal halide films were substantially converted into the perovskite compound only by dipping the porous metal halide film in the organic halide solution for 10 seconds.

In addition, it could be appreciated through absorption spectra of Comparative Examples 1 and 3 that it was difficult to remove all the guest molecule of the precursor film only by dipping the precursor film in chlorobenzene for 20 seconds, and thus the adduct remained in the metal halide film, and thus it could be appreciated that Comparative Examples 1 and 3 required a longer time at the time of the conversion into the perovskite compound even though it was relatively faster than the precursor film itself.

FIG. 6 shows the result of X-ray diffraction of the perovskite compound converted by dipping the porous metal halide film of Example 1 in the organic halide solution for 30 seconds, and the result of X-ray diffraction of the film converted by dipping the metal halide film of Comparative Example 2 for 30 seconds in the organic halide solution. As appreciated in FIG. 6, it could be confirmed once again that when the perovskite compound was converted by removing the guest molecule using chlorobenzene from the precursor film, a large amount of metal halide was non-converted but remained, and it could be appreciated that the perovskite compound fabricated by the conversion also exhibited strong (001) preferred orientation as conventionally known. However, it could be appreciated that in the perovskite compound films fabricated through Examples, the residual metal halide was not substantially present, and the perovskite compound film having remarkably suppressed (001) preferred orientation, further having completely random orientation as appreciated from the GIWAXS observation result described later, was fabricated.

(Example 3)

$PbI_2$ powder (lead iodide, 99%) purchased from Sigma-Aldrich Co., was added and dissolved in a mixed solvent including methyl sulfoxide (DMSO and N,N-dimethylformamide (DMF) at a volume ratio of 1 : 9 to prepare a solution having a concentration of 0.6 g/ml, followed by filtering with a 0.2 μm polytetrafluoroethylene (PTFE) syringe filter, thereby preparing an adduct solution. Here, a molar ratio of $PbI_2$ : DMSO in the adduct solution was 1 : 1.08.

$SnO_2$ nanoparticle water suspension (Alfa Aesar, 2.67 wt% water suspension) was injected into the center of rotation on an FTO substrate (glass substrate coated with fluorine-containing tin oxide, FTO: F-doped $SnO_2$, 8 ohms/$cm^2$, Pilkington), followed by spin coating for 30 seconds at a rotation speed of 2000 rpm, and annealing at 150°C for 30 seconds, thereby fabricating an annealed $SnO_2$ film. Then the annealed $SnO_2$ film was spin-coated with $SnCl_4 \cdot 5H_2O$ (Sigma-Aldrich) isopropanol solution having a concentration of 50 mM at 2000 rpm for 20 seconds and then annealed at 180°C for 1 hour to fabricate an FTO substrate on which a dense $SnO_2$ electron transport film was formed (hereinafter referred to as a lower substrate).

The prepared adduct solution was injected at a time into the center of rotation of the fabricated lower substrate, and spin-coated at a rotation speed of 2000 rpm for 30 seconds, thereby fabricating a dried precursor film (film thickness of 0.45 μm).

The fabricated precursor film was dipped in isopropyl alcohol (anhydrous 2-propanol, IPA, Sigma-Aldrich) for 10 seconds, and then the film was recovered, and dried at room temperature by weakly blowing with air gun, thereby fabricating a porous metal halide film from which the guest molecule was removed.

For an organic halide solution, MAI and MACl were added to isopropyl alcohol so that a total weight of the organic halide was 100% including 80 wt% of $CH_3NH_3I$ (MAI, Greatcell Solar Ltd.) and 20 wt% of $CH_3NH_3Cl$ (MACl, Sigma-Aldrich), thereby preparing an organic halide solution having a concentration of 40 mg (a total weight of MAI and MACl)/ml.

The fabricated porous metal halide film was dipped in the prepared organic halide solution for 30 seconds, and then the film was recovered, and dried at room temperature by weakly blowing with air gun, thereby fabricating a perovskite compound film.

(Example 4)

A porous metal halide film and a perovskite compound film were fabricated in the same manner as in Example 3, except that water instead of isopropyl alcohol was used as the polar protic solvent to remove the guest molecule.

(Comparative Example 4)

A metal halide film and a perovskite compound film were fabricated in the same manner as in Example 3, except that the fabricated precursor film was heat-treated at a temperature of 80 °C for 30 minutes to remove the guest molecule.

FIGS. 7A to 7C show scanning electron microscope (SEM) images of the precursor film (FIG. 7A), the porous metal halide film (FIG. 7B), and the perovskite compound film (FIG. 7C) fabricated in Example 3. As appreciated from FIG. 7, it could be appreciated that only by the contact for 10 seconds, the guest molecule was removed from the precursor film, and the porous metal halide film having uniform pores was fabricated, and only by the contact for 30 seconds with the organic halide solution, the porous metal halide film was converted into a dense perovskite compound film in which residual pores were substantially absent.

Further, as results of X-ray diffraction analysis of the precursor film, the porous metal halide film, and the perovskite compound film fabricated in Example 3, it was confirmed that the film having the (101) preferred orientation in which the I(101)/(I(001) ratio was 17 was fabricated, that the adduct did not remain in the fabricated porous metal halide film, and that the metal halide did not remain even in the fabricated perovskite compound film.

FIGS. 8A and 8B show scanning electron microscope (SEM) images of the porous metal halide film (FIG. 8A), and the perovskite compound film (FIG. 8B) fabricated in Example 4. Accordingly, when a polar protic solvent having excessively strong hydrogen bonding force, which satisfies Relational Expression 6, but is out of Relational Expression 6', was used, it could be confirmed that when the guest molecule was removed, etching (partial dissolution) of the metal halide by the solvent occurred, and thus flat plate type granulation in which a thermodynamically stable low-index surface forms a surface occurred, and it could be appreciated that a low quality perovskite compound film in which a large amount of pores remained when being converted into the perovskite compound was fabricated. In addition, it could be confirmed that reactivity with the organic halide was deteriorated due to the plate granulation in which the stable low-index surface forms the surface, and thus the unreacted metal halide remained in the X-ray diffraction analysis.

The GIWAXS measurement was performed using PAL (Pohang Accelerator Laboratory) beamline 6D. An incident angle of the X-ray (11.6 eV) was 0.34°, and the time for which the sample to be measured is exposed to X-ray

was 60 seconds.

FIG. 9 shows scattering intensity of the (101) plane according to the azimuthal angle (Heat_$PbI_2$ in FIG. 9) in the GIWAXS spectrum of the porous metal halide film fabricated in Comparative Example 4 and scattering intensity of the (101) plane according to the azimuthal angle (MET_$PbI_2$ in FIG. 9) in the GIWAXS spectrum of the porous metal halide film fabricated in Example 3.

In addition, FIG. 10 shows scattering intensity of the (110) plane according to the azimuthal angle (Heat_$MAPbI_3$ in FIG. 10) in the GIWAXS spectrum of the perovskite compound film fabricated in Comparative Example 4 and scattering intensity of the (110) plane according to the azimuthal angle (MET_$MAPbI_3$ in FIG. 10) in the GIWAXS spectrum of the perovskite compound film fabricated in Example 3.

Similar to the X-ray diffraction results observed previously, as shown in FIG. 9, it could be appreciated that when removing the guest molecule by heat, the peak appeared at 55 degrees which is an angle between the (001) plane and the (101) plane, and thus the (001) preferred orientation in which the surface of the film and the (001) plane are parallel to each other appeared. However, it could be appreciated that in the porous metal halide film fabricated in Example 3, the (001) preferred orientation did not substantially appear, and further, the (101) surface also had a radially random crystal orientation. Specifically, it could be appreciated that in the porous metal halide film fabricated in Example 3, 155/110 = 0.8 and 155/180 = 1.23, and thus any particular radial orientation was not shown, whereas in Comparative Example 4 in which the guest molecule was removed by heat, 155/110 = 3.76 and 155/180 = 5.2, and thus the (101) surface formed a strong peak at 55 degrees due to the orientation in which the (001) plane is oriented parallel to the surface of the film.

(Example 5)

A porous metal halide film was fabricated in the same manner as in Example 3 except that isopropyl alcohol was applied to the precursor film using spin coating (3000 rpm, 30 seconds) instead of dipping the fabricated precursor film in isopropyl alcohol for 10 seconds.

Through scanning electron microscope images, it was confirmed that regardless of the application method, the metal halide films fabricated in Example 3 and Example 5 had substantially the same porous structure. As appreciated in FIG. 11 showing the X-ray diffraction patterns of the porous metal halide film fabricated in Example 3 and the porous metal halide film fabricated in Example 5, it was confirmed that the porous metal halide films had substantially the same (101) preferred orientation regardless of the application method were fabricated.

(Example 6)

A porous metal halide film and a perovskite compound film were fabricated in the same manner as in Example 3 except that the precursor film was fabricated by preparing an adduct solution at a concentration of 0.3 g/ml instead of 0.6 g/ml, and printing the prepared adduct solution with a gap of 10 μm and a rate of 10 mm/sec on a lower substrate having a size of 10 cm x 10 cm using a slot-die coater (PMC-200, PEMS, South Korea).

FIG. 12 is an optical image of the perovskite compound film fabricated in Example 6 As appreciated in FIG. 12, it could be confirmed that the porous metal halide film even in a large area of 10 cm x 10 cm was uniformly converted into the perovskite compound. In addition, as the result of the scanning electron microscopic observation and the X-ray diffraction analysis, it was confirmed that a porous metal halide film and a perovskite compound film that were substantially the same as the porous metal halide film and the perovskite compound film fabricated by spin coating in Example 3 were fabricated in a large area of 10 cm x 10 cm. Further, it was confirmed that the pore uniformity of Relational Expression 5 and further Relational Expression 5' was satisfied even in a large area of 10 cm × 10 cm, and it was confirmed that |Ap(center)-Ap(corner)|/Ap(center) * 100 was only 5%.

(Example 7)

An organic hole transport layer and an Au electrode were sequentially formed on the laminate of the lower substrate-perovskite compound film fabricated in Example 3. In detail, as the organic hole transport layer, a hole transport layer having a thickness of 0.2 μm was formed by using a hole transport liquid prepared by mixing 23 μL of acetonitrile solution (540 mg/ml) in which bis(trifluoromethane)sulfonimide lithium salt (Li-TFSI) was dissolved, 39 μL of 4-tert-butylpyridine (tBP, Sigma-Aldrich), and 10 μL of an acetonitrile solution (0.376 g/ml) in which tris(2-(1H-pyrazol-1-yl)-4-tert-butylpyridine cobalt (III)tri[bis(trifluoromethane)sulfonamide] (FK209, LumTec) was dissolved, in a solution in which 2,2',7,7'-tetrakis-(N,N-di-4-methoxyphenylamino)-9,9'-spirobifluorene (spiro-OMeTAD, LumTec) was dissolved in chlorobenzene at 90.9 mg/ml. Then, Au was vacuum deposited on the formed hole transport layer using a high vacuum (5 x $10^{-6}$ torr or less) thermal evaporator to form an Au electrode with a thickness of 70 nm, thereby fabricating a solar cell.

(Example 8)

A laminate having a perovskite compound film on a lower substrate was fabricated in the same manner as in Example 3 except that a dipping time in the polar protic solvent for converting the porous metal halide film into the perovskite compound film was 180 seconds instead of 30 seconds, and a hole transport layer and an Au electrode were formed on the fabricated laminate in the same manner as in Example 7 to fabricate a perovskite solar cell.

(Example 9)

The perovskite compound film converted from the porous metal halide film was annealed for 60 seconds at a temperature of 100°C, and then a hole transport layer and an Au electrode were formed on the annealed perovskite compound film in the same manner as in Example 7 without forming the hole transport layer directly on the laminate in which the perovskite compound film was formed on the lower substrate fabricated in the same manner as in Example 3, thereby fabricating a perovskite solar cell.

In order to confirm photoelectric characteristics of the fabricated solar cell, open-circuit voltage ($V_{OC}$), short-circuit current density ($J_{SC}$), and fill factor (FF) of the fabricated solar cell were measured under condition of AM1.5G using an artificial solar device (ORIEL class A solar simulator, Newport, model 91195A) and a source-meter (Kethley, model 2420). An active area when measuring efficiency was 0.096 $cm^2$.

The solar cell fabricated in Example 7 was fabricated by an extremely short process for a total of 40 seconds including the removal of the guest molecule by isopropyl alcohol for 10 seconds and the conversion into the perovskite compound film for 30 seconds, and in addition, it was confirmed that even though $SnO_2$ having a dense film instead of $TiO_2$ having an excellent electron transport property was used as an electron carrier, the solar cell of Example 7 had very high photoelectric conversion efficiency of 15.9%.

Further, it was confirmed that when the time for contact with the organic halide was further increased as in Example 8, even though the thermal annealing for improving the film quality was not performed after the perovskite compound film was fabricated, the fabricated solar cell showed $V_{OC}$ of 1.12 V, $J_{SC}$ of 22.4 $mA/cm^2$, and FF of 72.2%, and had very good photoelectric conversion efficiency of 18.2%.

It was confirmed that in Example 9 in which the solar cell was fabricated by annealing at a temperature of 100°C for 60 seconds after the removal of the guest molecule by isopropyl alcohol for 10 seconds and the conversion into the perovskite compound film for 30 seconds, the photoelectric conversion efficiency was increased to 18.4% by thermal annealing. These results of the photoelectric conversion efficiencies of 18.2% and 18.4% indicate that the film quality of the perovskite compound film fabricated by reacting the porous metal halide film fabricated according to an embodiment of the present disclosure with the organic halide had extremely good quality, which is comparable to film quality of a perovskite compound film having improved crystallinity and crystal grain size by annealing. In addition, the results of Examples 7 to 9 show that it was possible to fabricate the perovskite solar cell having a photoelectric conversion efficiency of 18% or more by extremely short processes including the removal of the guest molecule by isopropyl alcohol for 10 seconds, the conversion into the perovskite compound film for 30 seconds, and annealing for 60 seconds (annealing of the fabricated perovskite compound film).

(Example 10)

The laminate of the lower substrate-perovskite compound film fabricated in Example 6 was uniformly divided into 12 pieces, and then a hole transport layer and an Au electrode were formed on each of the divided laminate pieces in the same manner as in Example 7, thereby fabricating 12 perovskite solar cells.

FIG. 13 shows the photoelectric conversion efficiency of each of 12 solar cells derived from a single perovskite compound film having a large area of 10 cm x 10 cm fabricated using slot-die coating, and FIG. 14 shows a current density-voltage curve of No. 9 solar cell having the best efficiency.

As appreciated in FIG. 13, the average photoelectric conversion efficiency of solar cells fabricated from a single large-area perovskite compound film was 17.3%, and the fabricated solar cells had very uniform efficiency in which efficiency deviation between solar cells was only 0.4%.

The metal halide film according to the present disclosure does not have (001) preferred orientation and has homogeneous pores even in a large area, thereby having an advantage of being converted into a substantially completely dense perovskite compound film only by contacting with the organic halide in an extremely short time such as several seconds to several tens of seconds.

The metal halide film may be rapidly mass-produced in a large area quickly by a continuous process which is extremely excellent in commerciality, in particular, a roll-to-roll process with a large area, etc., due to uniform quality over a large area and an extremely short reaction time.

The fabrication method of a metal halide film according to the present disclosure is advantageous in that the

porous metal halide film having the homogeneous pores even in a large area is fabricated by removing the guest molecules of the precursor film uniformly and substantially completely even in a large area through the simple process of contacting the precursor film containing the adduct of metal halide and guest molecule and a selected solvent (a selected polar protic solvent) for several seconds to several tens of seconds. In addition, the metal halide film according to the present disclosure does not have (001) preferred orientation and has random (101) orientation, and thus even though it is a thick metal halide film having a thickness of up to 100 μm, it is possible to fabricate a porous metal halide film capable of being converted into a substantially completely dense perovskite compound film without containing a non-reacted product only by contacting with the organic halide in an extremely short time such as several seconds to several tens of seconds.

Further, the fabrication method of a metal halide film according to the present disclosure is advantageous in that since the porous metal halide film having uniform properties even in a large area is fabricated by formation of the precursor film based on printing - instant contact with the selected solvent (several seconds to several tens of seconds), the metal halide film is capable of being mass-produced at a low cost in a short time by a continuous process such as a roll-to-roll process based on a printing process.

The fabrication method of an organometal halide film having a perovskite-structure (a perovskite compound film) according to the present disclosure is advantageous in that even though it is a thick metal halide film having a thickness of up to 100 μm, it is possible to fabricate a substantially completely dense perovskite compound film without containing a non-reacted product only by contacting with the organic halide in an extremely short time such as several seconds to several tens of seconds due to porosity of the metal halide film and grain orientation of the metal halide film caused by the selected solvent (the selected polar protic solvent).

Hereinabove, although the present disclosure is described by specific matters, limited exemplary embodiments, and drawings, they are provided only for assisting in the entire understanding of the present disclosure. Therefore, the present disclosure is not limited to the exemplary embodiments. Various modifications and changes may be made by those skilled in the art to which the present disclosure pertains from this description.

Therefore, the spirit of the present disclosure should not be limited to the above-described exemplary embodiments, and the following claims as well as all modified equally or equivalently to the claims are intended to fall within the scopes and spirit of the disclosure.

## Claims

1. A porous metal halide film satisfying Relational Expression 1 below:

(Relational Expression 1)

$$I(101)/I(001) \geq 0.5$$

in Relational Expression 1, 1(101) is a diffraction intensity of a (101) plane in X-ray diffraction pattern using a Cu Kα line of the porous metal halide film, and I(001) is a diffraction intensity of the (001) plane in the same X-ray diffraction pattern.

2. The porous metal halide film of claim 1, wherein the I(101)/I(001) is 5 or more.

3. The porous metal halide film of claim 1, wherein in a grazing incidence wide angle X-ray scattering (GIWAXS) spectrum, the metal halide film has a continuous scattering intensity in a azimuthal angle range of 10 to 80 degrees based on a scattering intensity of the (101) plane according to the azimuthal angle, and further satisfies Relational Expressions 2 and 3 below:

(Relational Expression 2)

$$0.7 \leq I55/I10 \leq 1.5$$

155 is an intensity at a azimuthal angle of 55 degrees based on a scattering intensity of a (101) plane according to the azimuthal angle, and I10 is an intensity at a azimuthal angle of 10 degrees based on the scattering intensity of the (101) plane according to the same azimuthal angle:

(Relational Expression 3)

$$0.7 \leq I55/I80 \leq 1.5$$

155 is the same as defined in the Relational Expression 2, and 180 is an intensity at a azimuthal angle of 80 degrees based on the scattering intensity of the (101) plane according to the azimuthal angle.

**4.** The porous metal halide film of claim 1, wherein the porous metal halide film further satisfies Relational Expression 4 below:

(Relational Expression 4)

$$Ap \geq 0.05$$

in Relational Expression 4, Ap means an area occupied by pores per unit area of the porous metal halide film.

**5.** The porous metal halide film of claim 1, wherein the porous metal halide film further satisfies Relational Expression 5 below:

(Relational Expression 5)

$$|Ap(center)-Ap(corner)|/Ap(center) * 100 \leq 10\%$$

in Relational Expression 5, Ap (center) means an area occupied by pores per unit area in a central region of a porous metal halide film based on a size of 2 inches by 2 inches, and Ap (corner) means an area occupied by pores per unit area in an edge region of the same porous metal halide film.

**6.** The porous metal halide film of claim 1, wherein the metal halide film has a thickness of 1 $\mu$m to 1000 $\mu$m.

**7.** The porous metal halide film of claim 1, wherein the metal halide film is reacted with an organic halide to be converted into an organometal halide having a perovskite structure, thereby fabricating the organometal halide.

**8.** A fabrication method of a porous metal halide film comprising:
contacting a precursor film (adduct layer) containing an adduct of metal halide and guest molecule with a polar protic solvent satisfying Relational Expression 6 below to fabricate a porous metal halide film:

(Relational Expression 6)

$$\delta_h(gm) < \delta_h(pa)$$

in Relational Expression 6, $\delta_h$(gm) is a hydrogen bonding component ($\delta_h$, MPa$^{0.5}$) in a Hansen solubility parameter of the guest molecule, and $\delta_h$(pa) is a hydrogen bonding component ($\delta_h$, MPa$^{0.5}$) in a Hansen solubility parameter of the polar protic solvent.

**9.** The fabrication method of claim 8, wherein the polar protic solvent further satisfies Relational Expressions 7 and 8 below:

(Relational Expression 7)

$$0.8 \leq \delta_t(pa) / \delta_t(gm) \leq 1.1$$

in Relational Expression 7, $\delta_t$(gm) is a Hansen solubility parameter (MPa$^{0.5}$) of the guest molecule, and $\delta_t$ (pa) is a Hansen solubility parameter (MPa$^{0.5}$) of the polar protic solvent, and

(Relational Expression 8)

$$7.0 \leq \delta_p(gm) - \delta_p(pa) \leq 15.0$$

in Relational Expression 8, $\delta_p$ (gm) is a dispersion component ($\delta_p$, $MPa^{0.5}$) in a Hansen solubility parameter of the guest molecule, and $\delta_p$(pa) is a dispersion component ($\delta_p$, $MPa^{0.5}$) in a Hansen solubility parameter ($MPa^{0.5}$) of the polar protic solvent.

**10.** The fabrication method of claim 8, wherein the polar protic solvent further satisfies Relational Expression 9 below:

(Relational Expression 9)

$$0.5 \leq V_m(pa)/V_m(gm) \leq 1.15$$

in Relational Expression 9, $V_m$(pa) is a molar volume of the polar protic solvent and $V_m$(gm) is a molar volume of the guest molecule.

**11.** The fabrication method of claim 8, wherein the guest molecule is a solvent of the metal halide.

**12.** The fabrication method of claim 8, wherein the guest molecule is dimethylsulfoxide (DMSO), N-methyl-2-pyrrolidone (NMP), 2,2'-bipyridine, 4,4'-bipyridine-N,N'-dioxide, pyrazine, 1,10-phenanthroline, 2-methylpyridine or poly(ethylene oxide).

**13.** The fabrication method of claim 8, wherein the polar protic solvent is an alcohol-based solvent.

**14.** The fabrication method of claim 8, further coomprising:

a) forming the precursor film containing an adduct of metal halide and guest molecule by applying an adduct solution containing the metal halide and the guest molecule on a substrate; and
b) forming the porous metal halide film by contacting the precursor film with the polar protic solvent.

**15.** The fabrication method of claim 14, wherein steps a) and b) are continuous processes.

**16.** The fabrication method of claim 14, wherein step a) is performed by a printing process including slot die, bar coater, gravure, offset, or doctor blade.

**17.** The fabrication method of claim 14, wherein the adduct solution contains 1 to 2.5 mol of guest molecules relative to 1 mol of the metal halide.

**18.** The fabrication method of claim 8, wherein a contact time between the precursor film and the polar protic solvent is within 1 minute.

**19.** The fabrication method of claim 14, wherein the adduct solution further contains a viscosity modifier, and in step b), the viscosity modifier contained in the precursor film is removed by the polar protic solvent.

**20.** A fabrication method of an organometal halide film comprising:

c) fabricating a porous metal halide film by the fabrication method of any one of claims 8 to 19; and
d) contacting the porous metal halide film with an organic halide to fabricate the organometal halide film having a perovskite structure.

**21.** The fabrication method of claim 20, wherein step d) is performed by contacting the porous metal halide film with an organic halide solution, and a concentration of the organic halide solution is 35 mg/ml or more.

**22.** The fabrication method of claim 20, wherein in step d), a contact time between the porous metal halide film and the organic halide is within 1 minute.

**23.** The fabrication method of claim 20, further comprising, after step d), annealing the organometal halide film fabricated in step d).

**24.** The fabrication method of claim 20, wherein step c) is performed on a substrate on which a first electrode and a first charge carrier are sequentially formed.

**25.** The fabrication method of claim 24, wherein the first charge carrier is a stacked body of a dense film and a porous film or is a dense film.

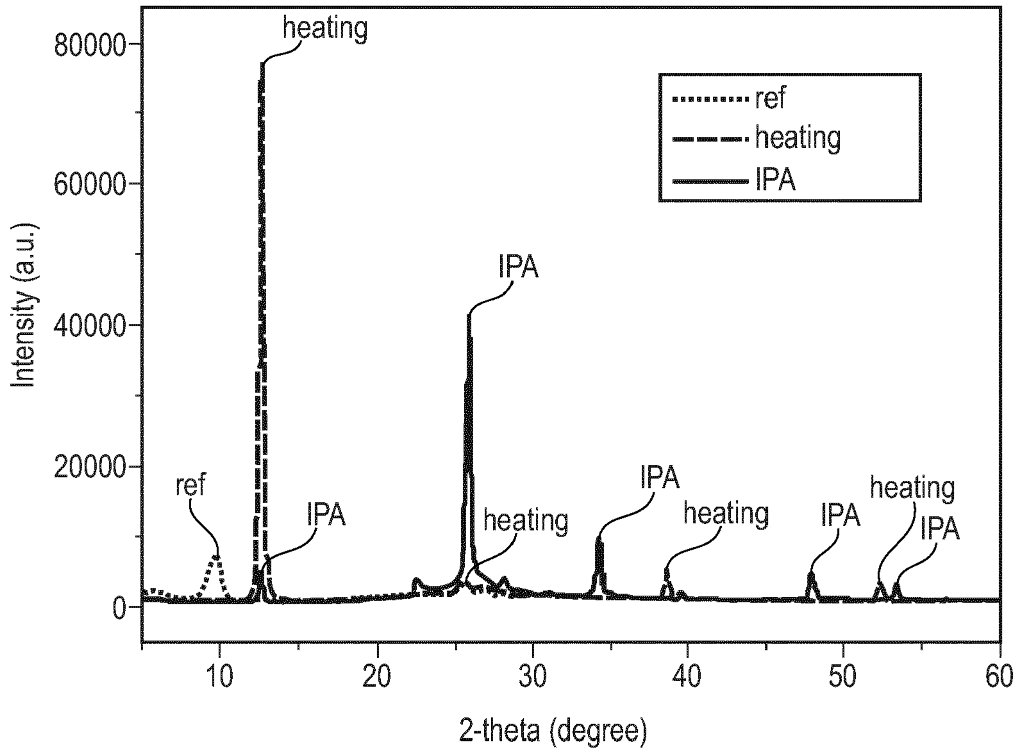

80000
60000
40000
20000
0
Intensity (a.u.)
10
20
30
40
50
60
2-theta (degree)
ref
heating
IPA
heating
ref
IPA
IPA
heating
IPA
heating
IPA
heating
IPA


Fig. 1

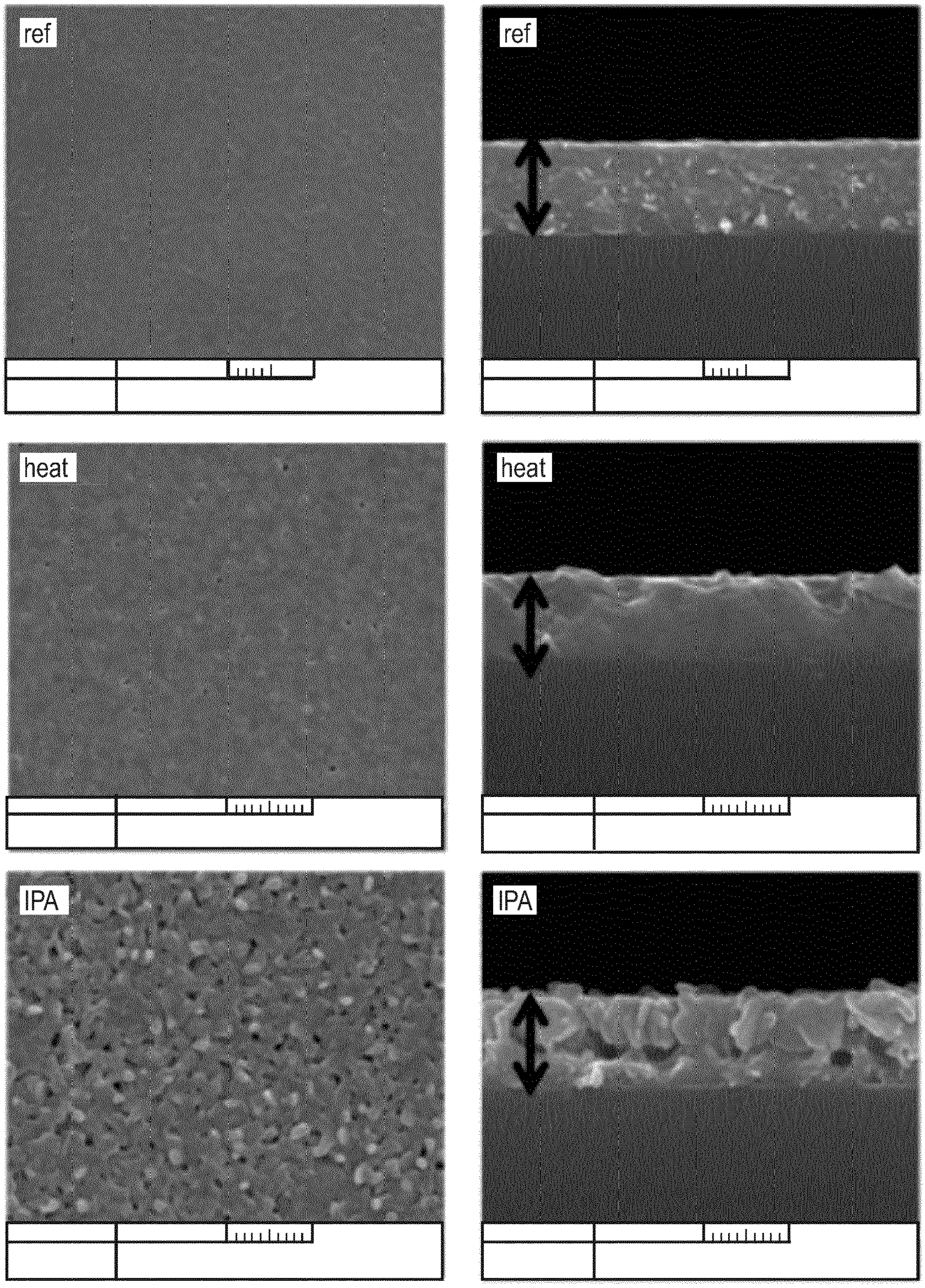


Fig. 2

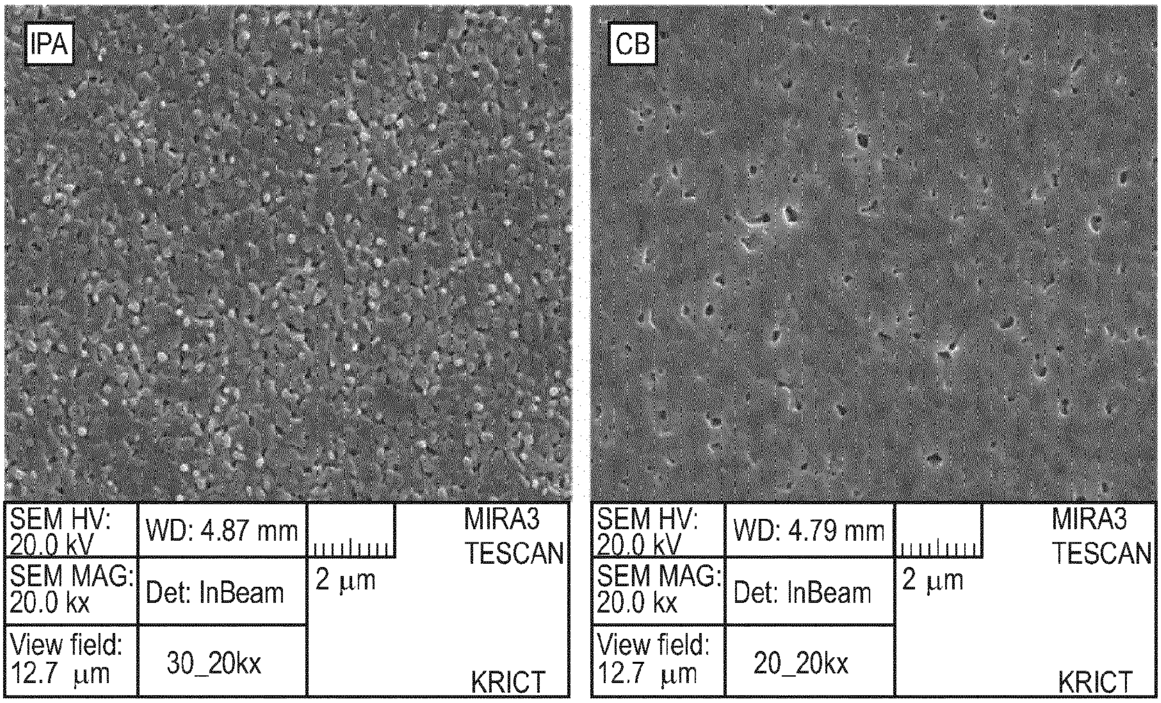
IPA
SEM HV: 20.0 kV
WD: 4.87 mm
MIRA3 TESCAN
SEM MAG: 20.0 kx
Det: InBeam
2 μm
View field: 12.7 μm
30_20kx
KRICT
CB
SEM HV: 20.0 kV
WD: 4.79 mm
MIRA3 TESCAN
SEM MAG: 20.0 kx
Det: InBeam
2 μm
View field: 12.7 μm
20_20kx
KRICT

Fig. 3

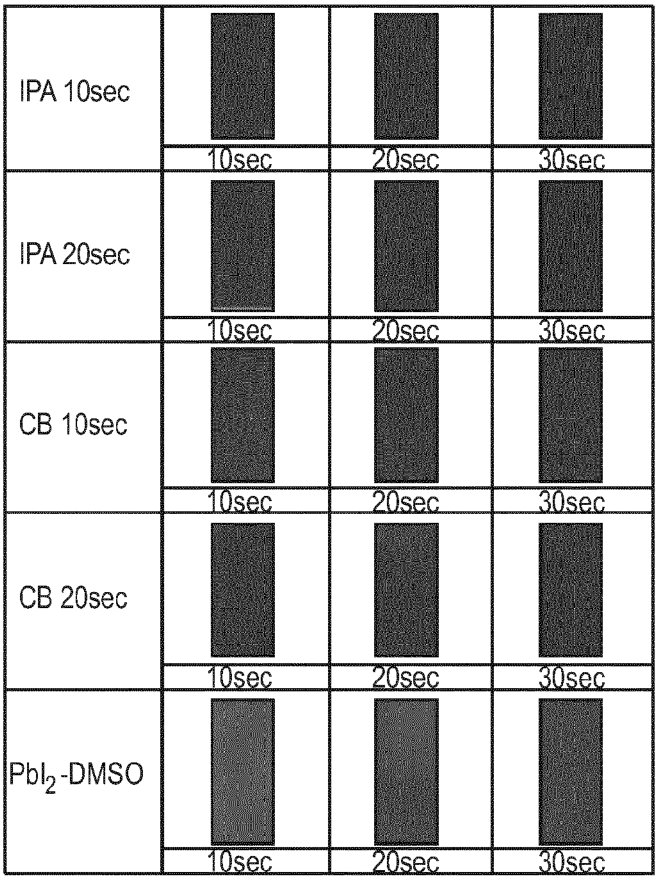
IPA 10sec
IPA 20sec
CB 10sec
CB 20sec
PbI2-DMSO
10sec
20sec
30sec

Fig. 4

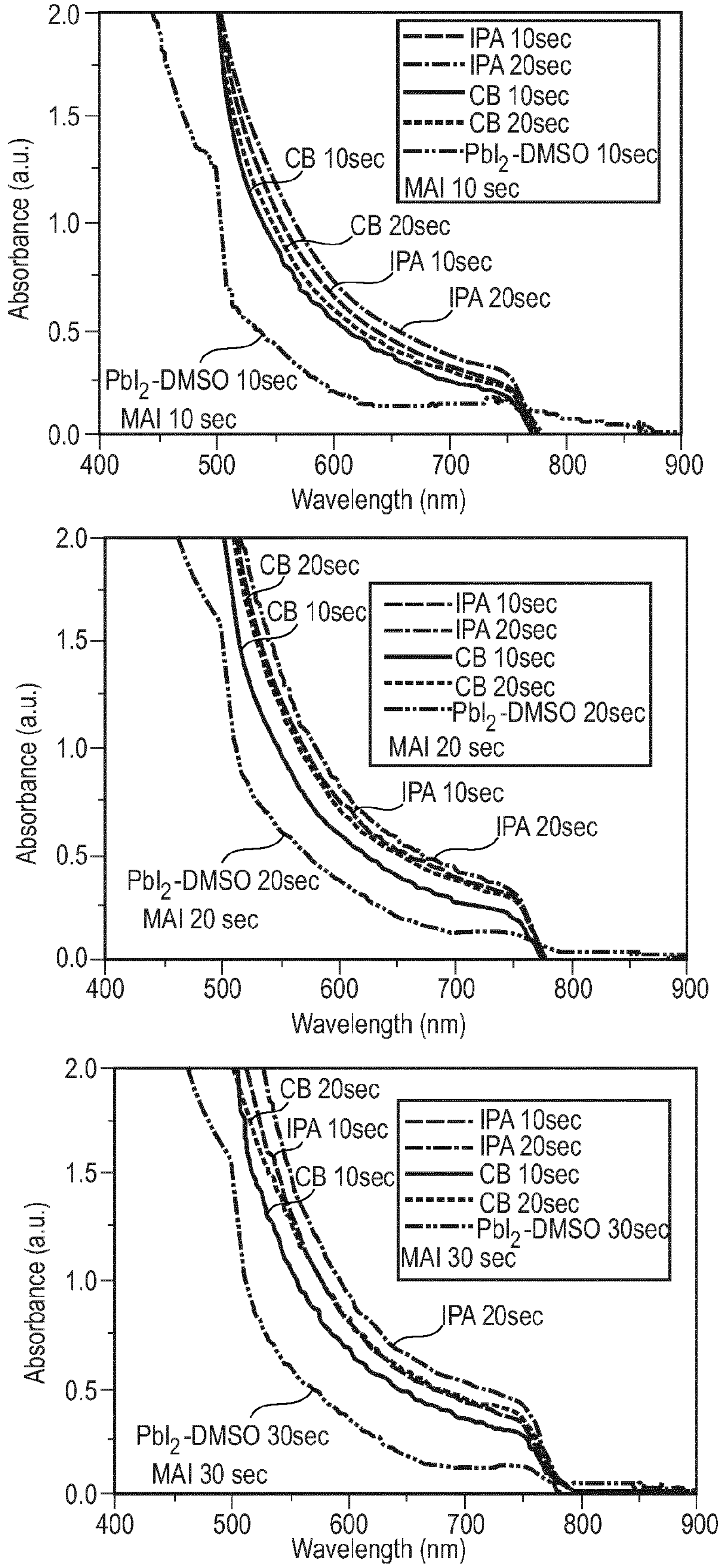
2.0
1.5
1.0
0.5
0.0
400
500
600
700
800
900
Absorbance (a.u.)
Wavelength (nm)
IPA 10sec
IPA 20sec
CB 10sec
CB 20sec
PbI2-DMSO 10sec
MAI 10 sec
PbI2-DMSO 20sec
MAI 20 sec
PbI2-DMSO 30sec
MAI 30 sec

Fig. 5

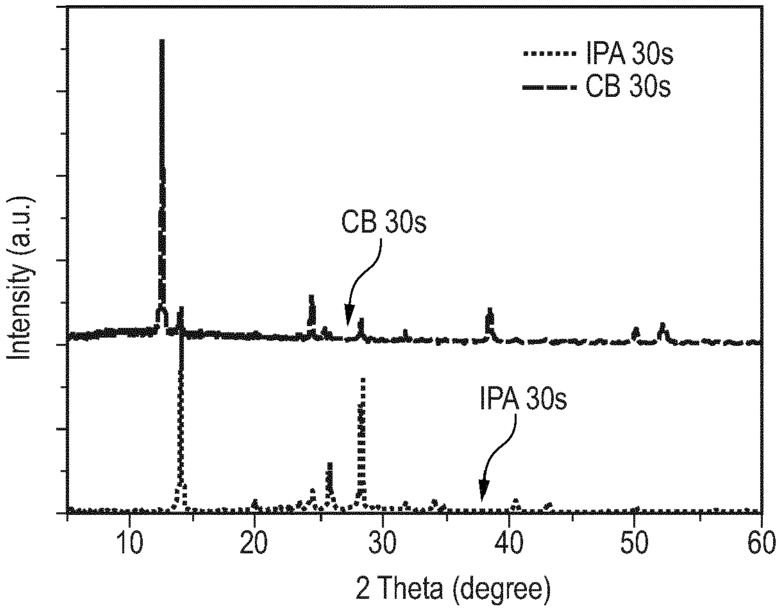


Fig. 6

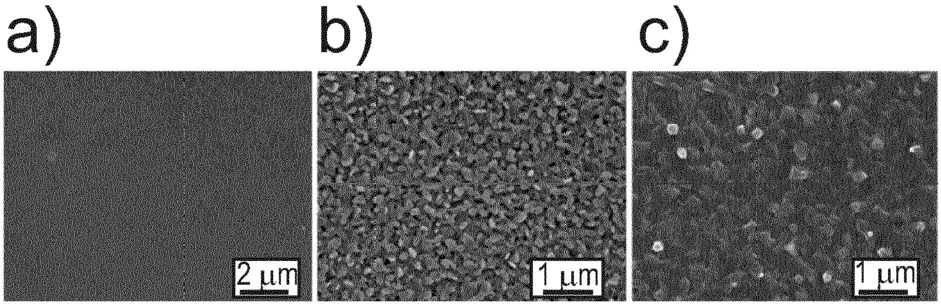


Fig. 7

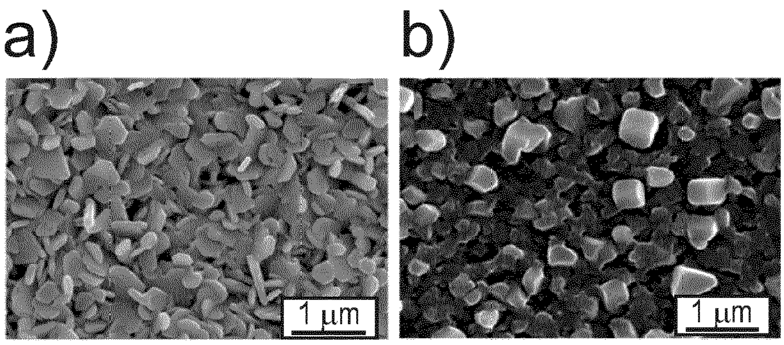


Fig. 8

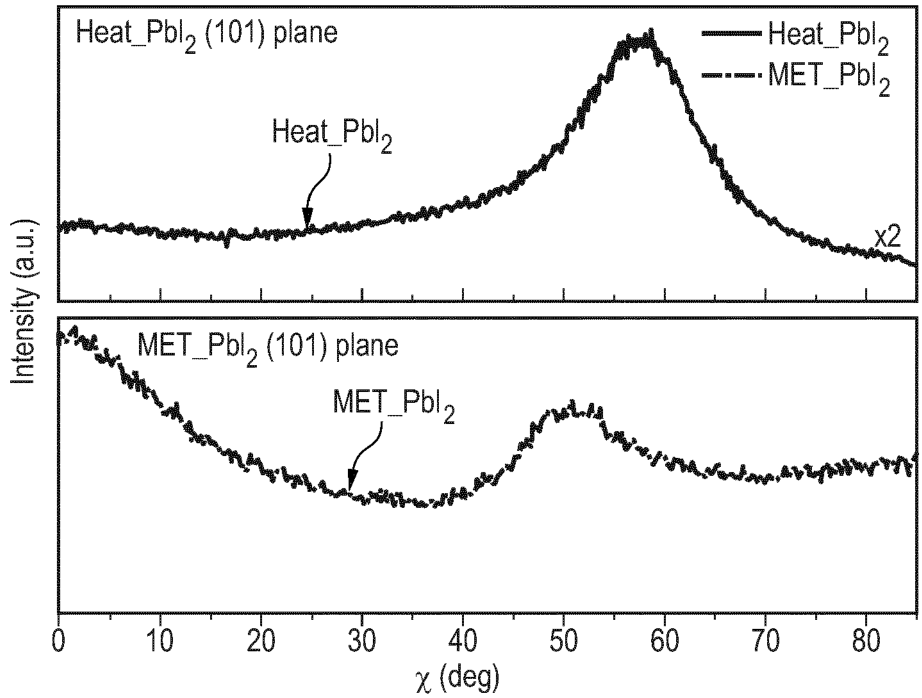
Heat_PbI2 (101) plane
Heat_PbI2
MET_PbI2
Heat_PbI2
x2
MET_PbI2 (101) plane
MET_PbI2
Intensity (a.u.)
0 10 20 30 40 50 60 70 80
χ (deg)

Fig. 9

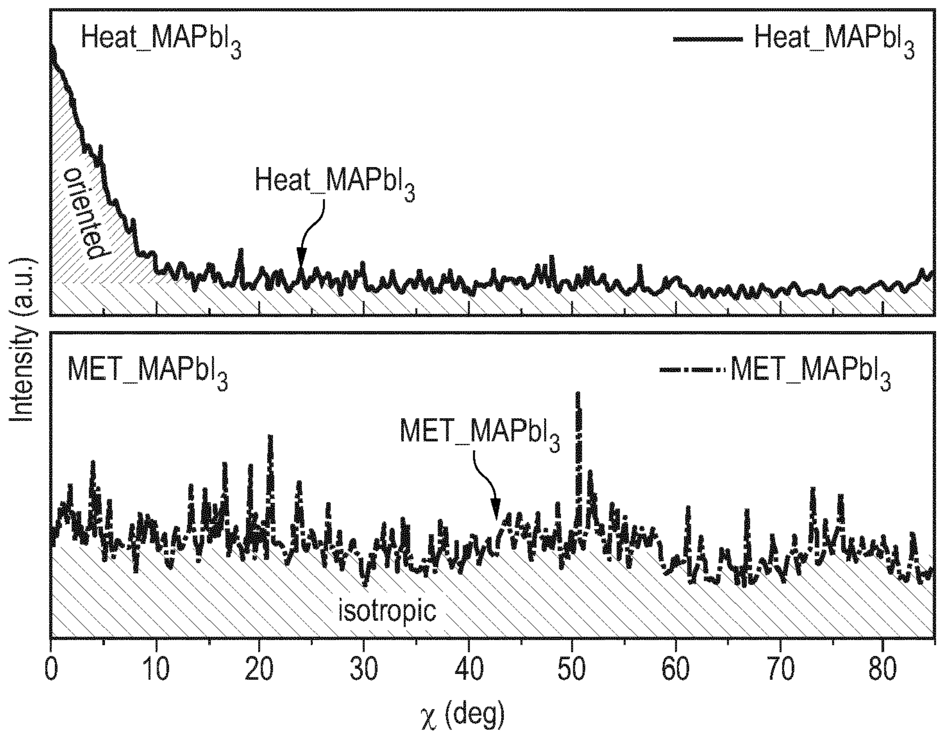
Heat_MAPbI3
Heat_MAPbI3
Heat_MAPbI3
oriented
MET_MAPbI3
MET_MAPbI3
MET_MAPbI3
isotropic
Intensity (a.u.)
0 10 20 30 40 50 60 70 80
χ (deg)

Fig. 10

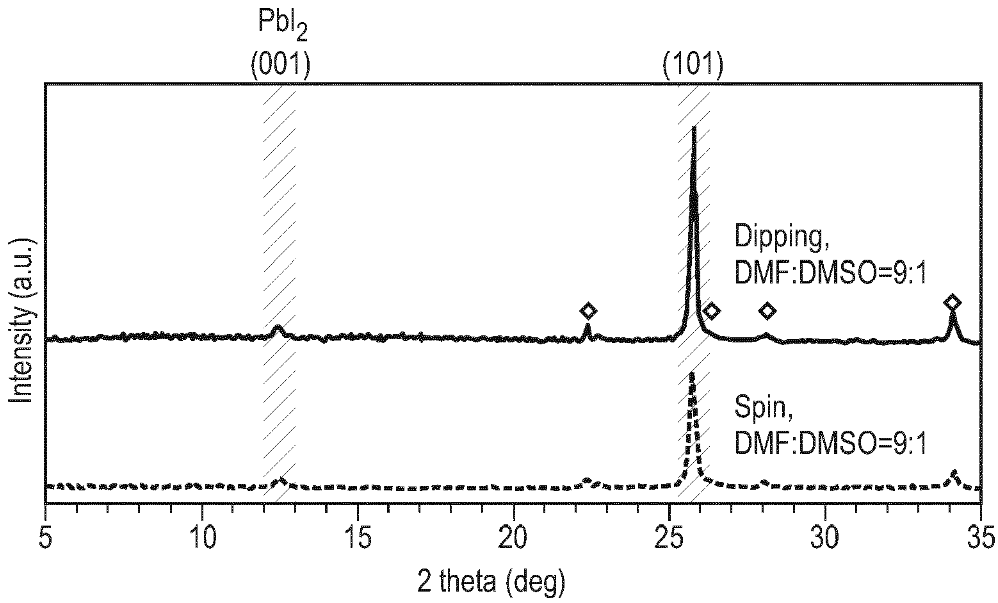
PbI2
(001)
(101)
Intensity (a.u.)
Dipping,
DMF:DMSO=9:1
Spin,
DMF:DMSO=9:1
5
10
15
20
25
30
35
2 theta (deg)

Fig. 11

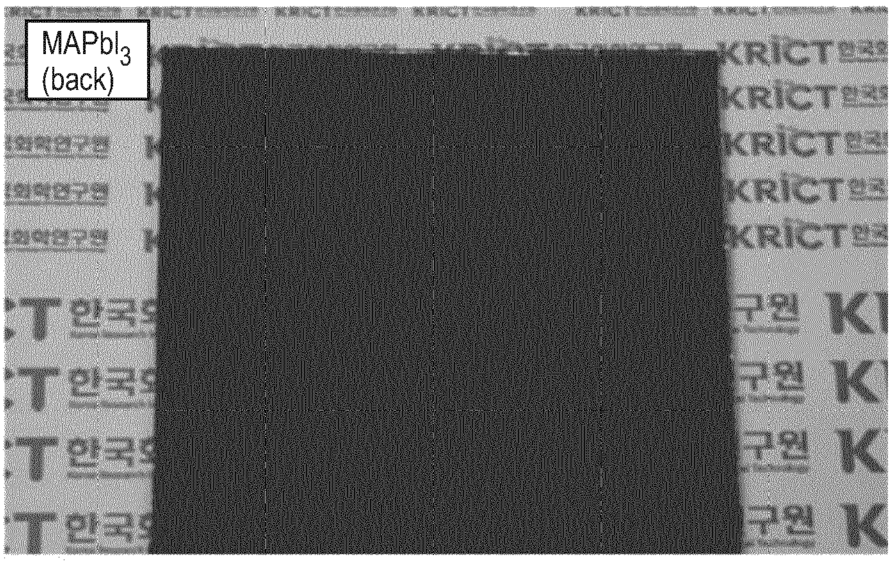
MAPbI3
(back)
KRICT

Fig. 12

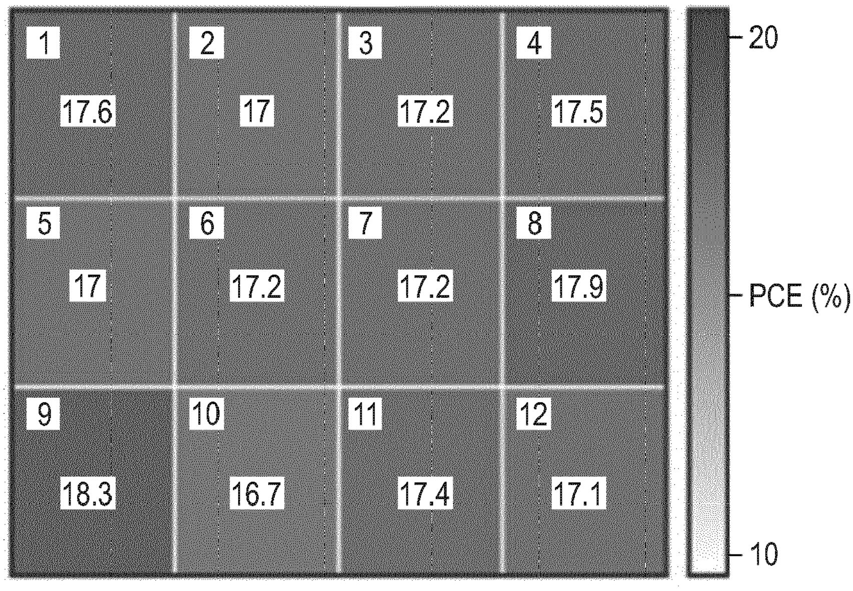
1
17.6
2
17
3
17.2
4
17.5
5
17
6
17.2
7
17.2
8
17.9
9
18.3
10
16.7
11
17.4
12
17.1
20
PCE (%)
10

Fig. 13

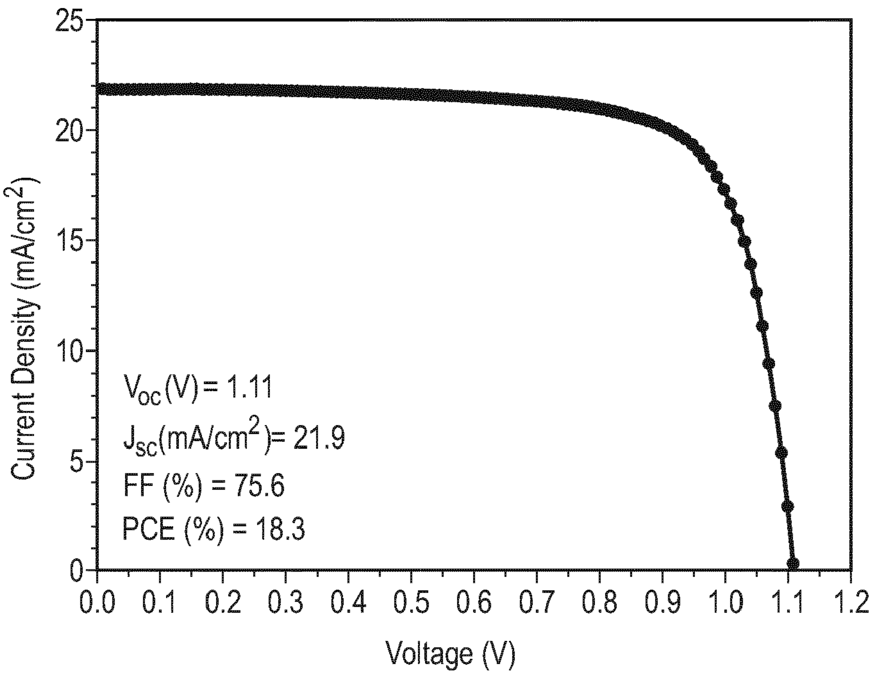
$V_{oc}$(V) = 1.11
$J_{sc}$(mA/cm$^2$)= 21.9
FF (%) = 75.6
PCE (%) = 18.3
Current Density (mA/cm$^2$)
Voltage (V)
0
5
10
15
20
25
0.0 0.1 0.2 0.3 0.4 0.5 0.6 0.7 0.8 0.9 1.0 1.1 1.2

Fig. 14

Europäisches Patentamt
European Patent Office
Office européen des brevets

# EUROPEAN SEARCH REPORT

Application Number
EP 18 16 1698

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 2016/322591 A1 (SEOK SANG IL [KR] ET AL) 3 November 2016 (2016-11-03)<br>* paragraphs [0057] - [0072] - paragraphs [0113] - [0115]; figure 1 *<br>----- | 1<br>2-20 | INV.<br>H01L51/46 |
| A | JULIAN BURSCHKA ET AL: "Sequential deposition as a route to high-performance perovskite-sensitized solar cells", NATURE, vol. 499, no. 7458, 10 July 2013 (2013-07-10), pages 316-319, XP055131813, ISSN: 0028-0836, DOI: 10.1038/nature12340<br>* abstract *<br>----- | 1-25 | |
| A | WO 2015/184197 A2 (ALLIANCE SUSTAINABLE ENERGY [US]) 3 December 2015 (2015-12-03)<br>* page 33, lines 17-23 *<br>----- | 1-20 | |
| | | | TECHNICAL FIELDS SEARCHED (IPC) |
| | | | H01L |

The present search report has been drawn up for all claims

1

| Place of search | Date of completion of the search | Examiner |
|---|---|---|
| The Hague | 6 July 2018 | Welter, Steve |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
..................................................
& : member of the same patent family, corresponding document

EPO FORM 1503 03.82 (P04C01)

## ANNEX TO THE EUROPEAN SEARCH REPORT ON EUROPEAN PATENT APPLICATION NO. EP 18 16 1698

This annex lists the patent family members relating to the patent documents cited in the above-mentioned European search report. The members are as contained in the European Patent Office EDP file on
The European Patent Office is in no way liable for these particulars which are merely given for the purpose of information.

06-07-2018

| Patent document cited in search report | Publication date | Patent family member(s) | Publication date |
|---|---|---|---|
| US 2016322591 A1 | 03-11-2016 | CN 105830228 A<br>JP 6339203 B2<br>JP 2017504960 A<br>KR 20160090845 A<br>US 2016322591 A1 | 03-08-2016<br>06-06-2018<br>09-02-2017<br>01-08-2016<br>03-11-2016 |
| WO 2015184197 A2 | 03-12-2015 | EP 3149765 A2<br>US 2017186559 A1<br>WO 2015184197 A2 | 05-04-2017<br>29-06-2017<br>03-12-2015 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 20140035284


### Non-patent literature cited in the description


- **CHARLES HANSEN.** Hansen Solubility Parameters: A User's Handbook. CRC Press, 2007
- **ALLAN F. M. BARTON.** *The CRC Handbook and Solubility Parameters and Cohesion Parameters,* 1999